(19) Europäisches Patentamt
European Patent Office
Office européen des brevets

(11) EP 2 556 532 B1

(12) EUROPEAN PATENT SPECIFICATION

(45) Date of publication and mention of the grant of the patent:
**20.12.2017 Bulletin 2017/51**

(21) Application number: **11766001.9**

(22) Date of filing: **01.04.2011**

(51) Int Cl.:
***H01L 21/027*** (2006.01) ***B29C 59/02*** (2006.01)
***C08F 20/00*** (2006.01) ***C08F 2/50*** (2006.01)
***C08F 2/40*** (2006.01)

(86) International application number:
**PCT/JP2011/058861**

(87) International publication number:
**WO 2011/126101 (13.10.2011 Gazette 2011/41)**

(54) **CURABLE COMPOSITION FOR IMPRINTS AND PRODUCING METHOD OF POLYMERIZABLE MONOMER FOR IMPRINTS**

HÄRTBARE ZUSAMMENSETZUNG FÜR ABDRÜCKE UND HERSTELLUNGSVERFAHREN FÜR POLYMERISIERBARES MONOMER FÜR ABDRÜCKE

COMPOSITION DURCISSABLE POUR IMPRESSIONS ET PROCÉDÉ DE FABRICATION D'UN MONOMÈRE POLYMÉRISABLE POUR IMPRESSIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.03.2011 JP 2011048810**
**07.04.2010 JP 2010088344**

(43) Date of publication of application:
**13.02.2013 Bulletin 2013/07**

(73) Proprietor: **FUJIFILM Corporation**
**Tokyo 106-8620 (JP)**

(72) Inventor: **KODAMA, Kunihiko**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A2- 1 431 315**
**EP-A2- 2 490 072**
**WO-A2-2010/064726**
**JP-A- 2004 143 281**
**JP-A- 2005 171 093**
**JP-A- 2005 173 252**
**JP-A- 2007 186 570**
**JP-A- 2008 058 642**
**JP-A- 2008 105 414**
**JP-A- 2009 215 179**
**KR-A- 20090 031 274**
**US-A1- 2007 191 506**
**US-A1- 2007 228 608**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 556 532 B1

## Description

### TECHNICAL FIELD

The present invention relates to a curable composition for imprints and a method for producing a curable composition for imprints, which includes a method of manufacturing a polymerizable monomer for imprints. More precisely, the invention relates to a curable composition for patterning through photoirradiation to give imprints, which is used in producing magnetic recording media such as semiconductor integrated circuits, flat screens, microelectromechanical systems (MEMS), sensor devices, optical discs, high-density memory discs, etc.; optical members such as gratings, relief holograms, etc.; optical films for production of nanodevices, optical devices, flat panel displays, etc.; polarizing elements, thin-film transistors in liquid-crystal displays, organic transistors, color filters, overcoat layers, pillar materials, rib materials for liquid-crystal alignment, microlens arrays, immunoassay chips, DNA separation chips, microreactors, nanobio devices, optical waveguides, optical filters, photonic liquid crystals, etc.

### BACKGROUND ART

Nanoimprint technology is a development advanced from embossing technology well known in the art of optical disc production, which comprises pressing a mold original with an embossed pattern formed on its surface (this is generally referred to as "mold", "stamper" or "template") against a resin to thereby accurately transfer the micropattern onto the resin through mechanical deformation of the resin. In this, when a mold is once prepared, then microstructures such as nanostructures can be repeatedly molded, and therefore, this is economical, and in addition, harmful wastes and discharges from this nanotechnology are reduced. Accordingly these days, this is expected to be applicable to various technical fields.

Two methods of nanoimprint technology have been proposed; one is a thermal nanoimprint method using a thermoplastic resin as the material to be worked (for example, see S. Chou, et al., Appl. Phys. Lett. Vol. 67, 3114 (1995)), and the other is a photonanoimprint method using a curable composition (for example, see M. Colbun, et al., Proc. SPIE, Vol. 3676, 379 (1999)). In the thermal nanoimprint method, a mold is pressed against a polymer resin heated up to a temperature not lower than the glass transition temperature thereof, then the resin is cooled and thereafter released from the mold to thereby transfer the microstructure of the mold onto the resin on a substrate. The method is applicable to various resin materials and glass materials and is expected to be applicable to various fields. For example, USP 5,772,905 and 5,956,216 disclose a nanoimprint method of forming nanopatterns inexpensively.

On the other hand, in the photonanoimprint method where a curable composition for photonanoimprints is photocured by photoirradiation through a transparent mold or a transparent substrate, the transferring material does not require heating in pressing it against the mold, and therefore the method enables room-temperature imprinting. Recently, new developments having the advantages of the above two as combined, have been reported, including a nanocasting method and a reversal imprint method for forming three-dimensional structures.

For the nanoimprint methods as above, proposed are applied technologies mentioned below.

In the first technology, the molded pattern itself has a function, and is applied to various elements in nanotechnology and to structural members. Its examples include various micro/nano optical elements and high-density recording media, as well as structural members in optical films, flat panel displays, etc. The second technology is for hybrid-molding of microstructures and nanostructures, or for construction of laminate structures through simple interlayer positioning, and this is applied to production of $\mu$-TAS (micro-total analysis system) and biochips. In the third technology, the formed pattern is used as a mask and is applied to a method of processing a substrate through etching or the like. In these technologies, high-precision positioning is combined with high-density integration; and in place of conventional lithography technology, these technologies are being applied to production of high-density semiconductor integrated circuits and transistors in liquid-crystal displays, and also to magnetic processing for next-generation hard discs referred to as patterned media. Recently, the action on industrialization of the above-mentioned nanoimprint technologies and their applied technologies has become active for practical use thereof.

As one example of nanoimprint technology, hereinunder described is an application to production of high-density semiconductor integrated circuits. The recent development in micropatterning and integration scale enlargement in semiconductor integrated circuits is remarkable, and high-definition photolithography for pattern transfer for realizing the intended micropatterning is being much promoted and advanced in the art. However, for further requirement for more definite micropatterning to a higher level, it is now difficult to satisfy all the three of micropattern resolution, cost reduction and throughput increase. Regarding this, as a technology of micropatterning capable of attaining at a low cost, nanoimprint lithography (photonanoimprint method) is proposed. For example, USP 5,772,905 and 5,259,926 disclose a nanoimprint technology of using a silicon wafer as a stamper for transferring a microstructure of at most 25 nm. This application requires micropatternability on a level of a few tens nm and high-level etching resistance of the micropattern functioning as a mask in substrate processing.

An application example of nanoimprint technology to production of next-generation hard disc drives (HDD) is described. Based on head performance improvement and media performance improvement closely connected with each other, the course of HDD history is for capacity increase and size reduction. From the viewpoint of media performance improvement, HDD has realized increased large-scale capacity as a result of the increase in the surface-recording density thereon. However, in increasing the recording density, there occurs a problem of so-called magnetic field expansion from the side surface of the magnetic head. The magnetic field expansion could not be reduced more than a certain level even though the size of the head is reduced, therefore causing a phenomenon of so-called sidelight. The sidelight, if any, causes erroneous writing on the adjacent tracks and may erase the already recorded data. In addition, owing to the magnetic field expansion, there may occur another problem in that superfluous signals may be read from the adjacent track in reproduction. To solve these problems, there are proposed technologies of discrete track media and bit patterned media of filling the distance between the adjacent tracks with a non-magnetic material to thereby physically and magnetically separate the tracks. As a method of forming the magnetic or non-magnetic pattern in production of these media, application of nanoimprint technology is proposed. The application also requires micropatternability on a level of a few tens nm and high-level etching resistance of the micropattern functioning as a mask in substrate processing.

Next described is an application example of nanoimprint technology to flat displays such as liquid-crystal displays (LCD) and plasma display panels (PDP).

With the recent tendency toward large-sized LCD substrates and PDP substrates for high-definition microprocessing thereon, photonanoimprint lithography has become specifically noted these days as an inexpensive lithography technology capable of being substituted for conventional photolithography for use in production of thin-film transistors (TFT) and electrode plates. Accordingly, it has become necessary to develop a photocurable resist capable of being substituted for the etching photoresist for use in conventional photolithography.

Further, for the structural members for LCD and others, application of photonanoimprint technology to transparent protective film materials described in JP-A-2005-197699 and 2005-301289, or to spacers described in JP-A-2005-301289 is being under investigation. Differing from the above-mentioned etching resist, the resist for such structural members finally remains in displays, and therefore, it may be referred to as "permanent resist" or "permanent film".

The spacer to define the cell gap in liquid-crystal displays is also a type of the permanent film; and in conventional photolithography, a photocurable composition comprising a resin, a photopolymerizable monomer and an initiator has been generally widely used for it (for example, see JP-A-2004-240241). In general, the spacer is formed as follows: After a color filter is formed on a color filter substrate, or after a protective film for the color filter is formed, a photocurable composition is applied thereto, and a pattern having a size of from 10 μm or 20 μm or so is formed through photolithography, and this is further thermally cured through past-baking to form the intended spacer.

Also an anti-reflective structure composed of a micro-pattern having a 50 to 300-nm pitch has been attracting public attention. Nanoimprint is useful also for forming the pattern. This sort of anti-reflective structure may be represented by a micro-dot pattern which is generally called "moth-eye", and is effective for improving anti-reflective performance of display surface, efficiency of solar energy utilization of solar cell, and light extraction efficiency of LED and organic EL device. In most cases of these applications, the thus-formed pattern remains in the final form of products, and is disposed in the outermost portion of the product, so that the anti-reflective structure is required to have excellent performance mainly regarding durability and strength of film, such as heat resistance, light resistance, solvent resistance, scratch resistance, good mechanical characteristics durable against external pressure, and hardness.

Further, nanoimprint lithography is useful also in formation of permanent films in optical members such as microelectromechanical systems (MEMS), sensor devices, gratings, relief holograms, etc.; optical films for production of nanodevices, optical devices, flat panel displays, etc.; polarizing elements, thin-film transistors in liquid-crystal displays, organic transistors, color filters, overcoat layers, pillar materials, rib materials for liquid-crystal alignment, microlens arrays, immunoassay chips, DNA separation chips, microreactors, nanobio devices, optical waveguides, optical filters, photonic liquid crystals, etc.

US 2011/003909 discloses a (meth)acrylate compound, excellent in photocurability, a curable composition comprising the compound, especially to provide a composition favorable for a permanent film for flat panel displays.

In application to such permanent films, the formed pattern remains in the final products, and is therefore required to have high-level properties of mainly film durability and strength, including heat resistance, light resistance, solvent resistance, scratch resistance, high-level mechanical resistance to external pressure, hardness, etc.

Almost all patterns heretofore formed in conventional photolithography can be formed in nanoimprint technology, which is therefore specifically noted as a technology capable of forming micropatterns inexpensively.

## SUMMARY OF THE INVENTION

It was, however, found that pattern transferability tends to degrade, for the case where the polymerizable monomer is used as a major constituent of the curable composition for imprints, in particular for the case where a

polymerizable monomer having a bifunctionality or higher degree of functionality. The present invention is aimed at solving the above-described problems, and an object of which is to provide a curable composition for imprints excellent in the pattern transferability.

The present inventors found out, after our thorough investigations, that some problems reside in manufacturing process of the polymerizable monomer used for the curable composition for imprints. More specifically, polymer component may undesirably be produced by polymerization of the polymerizable monomers, in the process of manufacturing of the polymerizable monomer. The polymerizable monomer is commercially sold as manufactured, since the amount of polymer component is very small, and may therefore not be detected even by GPC. The present inventors, however, found that such trace amount of polymer component seriously affect the pattern transferability of the curable composition for imprints, and completed the present invention based on the finding. More specifically, we have found that the above-described problems may be solved by the means below.

(1) A curable composition for imprints as defined in the claims, which comprises a polymerizable monomer (A) and a polymerization initiator (B), and which is substantially free from a polymer which contains at least one species of the polymerizable monomer (A) as a repeating unit.
(2) The curable composition for imprints according to (1), which has a turbidity of 1,000 ppm or below when dissolved in a solvent capable of dissolving therein the polymerizable monomer (A) contained in the curable composition for imprints, but incapable of, or nearly incapable of dissolving therein the polymer containing the polymerizable monomer (A) as a repeating unit, so as to adjust the total content of the polymerizable monomer (A) and the polymer containing the polymerizable monomer (A) as a repeating unit, contained in the curable composition for imprints, to 10% by mass of the solvent.
(3) The curable composition for imprints according to (1) or (2), wherein the polymerizable monomer (A) has a boiling point of 200°C or higher at 1 atm, or after being converted to 1 atm.
(4) The curable composition for imprints according to any one of (1) to (3), wherein the polymerizable monomer (A) has two or more polymerizable functional groups.
(5) The curable composition for imprints according to any one of (1) to (4), wherein the polymerizable monomer (A) contains an aromatic group and/or alicyclic hydrocarbon group.
(6) Also part of the present disclosure is the curable composition for imprints according to any one of (1) to (5), wherein the polymer containing at least one species of the polymerizable monomer (A) as a repeating unit shows a ratio of area ascribable to polymer component of 1% or smaller, when measured by gel permeation chromatography (GPC) using a differential refractometer (RI detector).
(7) Also part of the present disclosure is the curable composition for imprints according to any one of (1) to (5), wherein the polymer containing at least one species of the polymerizable monomer (A) as a repeating unit is not detected, when measured by gel permeation chromatography (GPC) using a differential refractometer (RI detector).
(8) Also part of the present disclosure is the curable composition for imprints according to any one of (1) to (5), wherein the polymer containing at least one species of the polymerizable monomer (A) as a repeating unit shows a ratio of area ascribable to polymer component of 50% or smaller, when measured by gel permeation chromatography (GPC) using a laser light scattering detector.
(9) The curable composition for imprints according to any one of (1) to (8), wherein the polymerizable monomer is (meth)acrylate.
(10) Also part of the present disclosure is the curable composition for imprints according to any one of (1) to (9), which contains two or more species of the polymerizable monomer (A), and contains substantially none of the polymers containing the polymerizable monomer (A) contained in the curable composition for imprints as a repeating unit.
(11) A method of manufacturing a curable composition for imprints, which includes a method of manufacturing a polymerizable monomer for imprints as defined in claim 1, which includes removing a polymer impurity containing the polymerizable monomer (A) as a repeating unit.
(12) The method of manufacturing a curable composition for imprints according to (11) includes a step of mixing a solvent capable of dissolving at least one species of the polymerizable monomer (A), but incapable of, or nearly incapable of dissolving the polymer containing the polymerizable monomer (A) as a repeating unit, with the polymerizable monomer (A), and the polymer containing at least one species of the polymerizable monomer (A) as a repeating unit; and allowing the polymer containing at least one species of the polymerizable monomer (A) as a repeating unit to deposit.
(13) The method of manufacturing a curable composition for imprints according to (11) and (12), wherein the solvent incapable of, or nearly incapable of dissolving the polymer containing the polymerizable monomer (A) as a repeating unit contains at least one species selected from alcoholic solvent, hydrocarbon solvent, water and ester solvent.
(14) The method of manufacturing a curable composition for imprints according to any one of (11) to (13), wherein the polymerizable monomer (A) has a boiling point of 200°C or higher at 1 atm, or after being converted to 1 atm.

(15) The method of manufacturing a curable composition for imprints according to any one of (11) to (14), wherein the polymerizable monomer (A) has two or more polymerizable functional groups.
(16) The method of manufacturing a curable composition for imprints according to any one of (11) to (15), wherein the polymerizable monomer (A) contains an aromatic group and/or alicyclic hydrocarbon group.
(17) The method of manufacturing a curable composition for imprints according to any one of (11) to (16), wherein the polymerizable monomer is (meth)acrylate.
(18) A method of manufacturing a curable composition for imprints according to (11) to (17) includes the method of manufacturing the polymerizable monomer for imprints.
(19) As is evident from (1) above, the present invention relates to a curable composition for imprints, which contains the polymerizable monomer manufactured by the method according to any one of (11) to (17).
(20) A method of forming a pattern, which includes:

forming a pattern-forming layer by applying, on a support, the curable composition for imprints according to any one of (1) to (10) and (19);
pressing a mold against the surface of the pattern-forming layer; and
irradiating light onto the pattern-forming layer.

(21) The method of forming a pattern according to (20), wherein the curable composition for imprints is applied on the support by spin coating or ink jet process.

A desirable pattern may now be formed by adopting the curable composition for imprints of the present invention. In particular, formability of pattern may now be improved in the process of forming an ultra-fine pattern.

DETAILED DESCRIPTION OF INVENTION

The contents of the invention are described in detail hereinunder. In this description, the numerical range expressed by the wording "a number to another number" means the range that falls between the former number indicating the lowermost limit of the range and the latter number indicating the uppermost limit thereof.
In this description, " (meth) acrylate" means acrylate and methacrylate; "(meth)acrylic" means acrylic and methacrylic; "(meth)acryloyl" means acryloyl and methacryloyl. In the invention, monomer is differentiated from oligomer and polymer, and the monomer indicates a compound having a weight-average molecular weight of at most 1,000. In this description, "functional group" means a group participating in polymerization.
"Imprint" referred to in the invention is meant to indicate pattern transfer in a size of from 1 nm to 10 mm and preferably meant to indicate pattern transfer in a size of from 10 nm to 100 μm (nanoimprint).
Regarding the expression of "group (atomic group)" in this description, the expression with no indication of "substituted" or "unsubstituted" includes both "substituted group" and "unsubstituted group". For example, "alkyl group" includes not only an alkyl group not having a substituent (unsubstituted alkyl group) but also an alkyl group having a substituent (substituted alkyl group).
The curable composition for imprints is defined in the claims and comprises the polymerizable monomer (A) and the (B) polymerization initiator, and is substantially free from a polymer containing at least one species of the polymerizable monomer (A) as a repeating unit.
The polymer containing the polymerizable monomer (A) as a repeating unit herein means so-called "impurity polymer", which is inevitably produced during manufacturing and storage of the polymerizable monomer (A), and during manufacturing and storage of the curable composition for imprints, due to polymerization among molecules of the polymerizable monomer (A). This is, therefore, totally different from polymer additive such as surfactant.
Now, "substantially free from a polymer" means that a ratio of area (peak ratio) corresponded to components ascribable to the polymerizable monomer (A), having molecular weight larger than that of the polymerizable monomer (A), relative to the polymerizable monomer (A), is generally 1% or smaller, when measured by gel permeation chromatography (GPC) using a differential refractometer (RI detector), preferably 0.5% or smaller, more preferably 0.1% or smaller, and still more preferably below the detection limit.
In gel permeation chromatography (GPC) of the polymerizable monomer (A), even a ultra-trace amount of polymer component which is not detectable by the RI detector, may be detectable in a highly sensitive manner. As a light scattering detector, both of a laser light scattering detector and an evaporative light scattering detector (ELSD) can detect the polymer ingredient at higher sensitivity than a RI detector. A laser light scattering detector can detect the polymer ingredient at higher sensitivity. Since scattering intensity in light scattering increases as particle size increases, so that a polymer having a larger molecular weight may be observed as a larger peak when the laser light scattering detector is used in GPC, and thereby the polymer may be detectable as a large peak in a highly sensitive manner, even if the amount thereof is actually so small as it cannot be detected by the RI detector. As the laser light scattering detector,

a multiple angle light scattering detector (MALS) is commercially available.

In a preferable embodiment of the present disclosure, a ratio of area (peak ratio) corresponded to components ascribable to the polymerizable monomer (A), having molecular weight larger than that of the polymerizable monomer (A), relative to the polymerizable monomer (A), is generally 50% or smaller, when measured by gel permeation chromatography (GPC) using a laser light scattering detector, preferably 30% or smaller, more preferably 10% or smaller, and particularly preferably below the detection limit.

In the present disclosure, if two or more species of the polymerizable monomer (A) are contained, the polymer containing the polymerizable monomer (A) as the repeating units includes homopolymers derived from the individual polymerizable monomers, and copolymer derived from two or more species of polymerizable monomer.

The present inventors found out from our investigations that it is difficult to detect a ultra-trace amount of polymer impurity by GPC, from the polymerizable monomer composition which contains the polymerizable monomer (A) and the polymer containing the polymerizable monomer (A) as a repeating unit, such as those commercially available as the polymerizable monomer. The present inventors also found that even a trace amount of polymer, and therefore cannot be detected by GPC, may adversely affect the imprint pattern. From this point of view, the polymerizable monomer composition contained in the curable composition for imprints of the present invention preferably shows a turbidity of 1,000 ppm or below when dissolved in a solvent capable of dissolving therein the polymerizable monomer (A) contained in the curable composition for imprints, but incapable of, or nearly incapable of dissolving therein the polymer containing the polymerizable monomer (A) as a repeating unit, so as to adjust the total content of the polymerizable monomer (A) and the polymer containing the polymerizable monomer (A) as a repeating unit, contained in the curable composition for imprints, to 10% by mass of the solvent. The turbidity is more preferably 700 ppm or below, still more preferably 500 ppm or below, furthermore preferably 100 ppm, particularly preferably 10 ppm or below, and most preferably 1 ppm or below.

The solvent herein, incapable of, or nearly incapable of dissolving therein the polymer containing the polymerizable monomer (A) as a repeating unit, means a solvent characterized by a solubility of polymer component of typically 5% by mass or below, and preferably 1% by mass or below, and preferably contains hydrocarbon solvent (pentane, hexane, heptane, toluene, xylene or benzene), or alcoholic solvent (methanol, ethanol, 1- or 2-propanol or 1- or 2-butanol).

The polymer component in the context of the present invention means a component having molecular weight larger than that of the polymerizable monomer (A), and also contains oligomer. The polymer component preferably has a weight-average molecular weight, measured by GPC, of 10,000 or larger, more preferably 30, 000 or larger, still more preferably 50,000 or larger, and most preferably 100,000 or larger. The curable composition may degrade the pattern transferability in imprint, if the polymer component of particularly large molecular weight is contained therein.

(Examples of Polymerizable Monomer Adoptable to the Present Invention)

Species of the polymerizable monomer adoptable to the curable composition for imprints used for the present invention is not specifically limited, without departing from the spirit of the present invention, and may be exemplified by polymerizable unsaturated monomer having 1 to 6 ethylenic unsaturated bond-containing groups; epoxy compound; oxetane compound; vinyl ether compound; styrene derivative; fluorine atom-containing compound; and propenyl ether or butenyl ether, preferably (meth)acrylate compound, epoxy compound, oxetane compound and vinyl ether compound.

The polymerizable unsaturated monomer having from 1 to 6 ethylenic unsaturated bond-having groups (mono- to hexa-functional polymerizable unsaturated monomer) is described below.

The polymerizable unsaturated monomer having one ethylenic unsaturated bond-having group (mono-functional polymerizable unsaturated monomer) includes concretely methyl(meth)acrylate, ethyl(meth)acrylate, butyl(meth)acrylate, N-vinyl pyrrolidinone, 2-acryloyloxyethyl phthalate, 2-acryloyloxy-2-hydroxyethyl phthalate, 2-acryloyloxyethyl hexahydrophthalate, 2-acryloyloxypropyl phthalate, 2-ethyl-2-butylpropanediol acrylate, 2-ethylhexyl (meth)acrylate, 2-ethylhexylcarbitol (meth)acrylate, 2-hydroxybutyl (meth)acrylate, 2-hydroxyethyl (meth)acrylate, 2-hydroxypropyl (meth)acrylate, 4-hydroxybutyl (meth)acrylate, acrylic acid dimer, benzyl (meth) acrylate, 1- or 2-naphthyl(meth)acrylate, butoxyethyl (meth)acrylate, cetyl (meth)acrylate, ethyleneoxide-modified (hereinafter this may be referred to as "EO") cresol (meth)acrylate, dipropylene glycol (meth)acrylate, ethoxylated phenyl (meth)acrylate, isoamyl (meth)acrylate, cyclopentanyl (meth)acrylate, isobornyl (meth)acrylate, dicyclopentanyl (meth)acrylate, dicyclopentanyloxyethyl (meth)acrylate, isomyristyl (meth)acrylate, lauryl (meth)acrylate, methoxydiproylene glycol (meth)acrylate, methoxytripropylene glycol (meth)acrylate, methoxypolyethylene glycol (meth)acrylate, methoxytriethylene glycol (meth)acrylate, neopentyl glycol benzoate (meth)acrylate, nonylphenoxypolyethylene glycol (meth)acrylate, nonylphenoxypolypropylene glycol (meth)acrylate, octyl (meth)acrylate, paracumylphenoxyethylene glycol (meth)acrylate, epichlorohydrin (hereinafter referred to as "ECH")-modified phenoxyacrylate, phenoxyethyl (meth)acrylate, phenoxydiethylene glycol (meth)acrylate, phenoxyhexaethylene glycol (meth)acrylate, phenoxytetraethylene glycol (meth)acrylate, polyethylene glycol (meth)acrylate, polyethylene glycol-polypropylene glycol (meth)acrylate, polypropylene glycol (meth)acrylate, stearyl (meth)acrylate, EO-modified succinic acid (meth)acrylate, tribromophenyl (meth)acrylate, EO-modified tribromophenyl (meth)acrylate, tridodecyl (meth)acrylate, *p*-isopropenylphenol, styrene, N-vinyl pyrrolidone, N-vinyl caprolactam.

Of those, especially preferred for use in the invention are a mono-functional (meth)acrylate having an aromatic structure and/or alicyclic hydrocarbon structure in view of improving dry etching resistance, more preferably a mono-functional (meth)acrylate having an aromatic structure. Specific examples thereof include benzyl (meth) acrylate, 1- or 2- naphthylmethyl (meth)acrylate, dicyclopentanyl (meth)acrylate, dicyclopentanyloxyethyl (meth)acrylate, isobornyl (meth)acrylate, adamantyl (meth)acrylate. More preferred examples thereof include benzyl (meth)acrylate, 1- or 2-naphthyl(meth)acrylate, or 1- or 2-naphtylmethyl (meth)acrylate.

Among the monofunctional polymerizable monomers having ethylenic unsaturated bond(s), monofunctional (meth)acrylate compound is preferably used in the present invention, from the viewpoint of photo-curability. The mono-functional (meth) acrylate compound may be exemplified by those previously exemplified as the monofunctional polymerizable monomers having ethylenic unsaturated bond(s).

Of those, especially preferred for use in the invention are a mono-functional (meth)acrylate having an aromatic structure and/or alicyclic hydrocarbon structure in view of improving dry etching resistance, more preferably a mono-functional (meth)acrylate having an aromatic structure. Specific examples thereof include benzyl (meth)acrylate, benzyl (meth) acrylate having a substituent on the benzene ring, wherein examples of preferable substituent include an alkyl group having 1 to 6 carbon atoms, an alkoxy group having 1 to 6 carbon atoms, and cyano group, 1- or 2- naphthylmethyl (meth)acrylate, dicyclopentanyl (meth)acrylate, dicyclopentanyloxyethyl (meth)acrylate, isobornyl (meth)acrylate, adamantyl (meth)acrylate. More preferred examples thereof include benzyl (meth)acrylate having a substituent on the benzene ring, and monofunctional (meth)acrylate compound having a naphthalene structure. Particularly preferred examples thereof include 1- or 2-naphthyl (meth)acrylate and 1- or 2-naphtylmethyl (meth)acrylate.

As the other polymerizable monomer, also preferred is a poly-functional polymerizable unsaturated monomer having two ethylenic unsaturated bond-containing groups.

Preferred examples of the di-functional polymerizable unsaturated monomer having two ethylenic unsaturated bond-containing groups for use in the invention include diethylene glycol monoethyl ether (meth)acrylate, dimethylol-dicyclopentane di(meth)acrylate, di(meth)acrylated isocyanurate, 1,3-butylene glycol di(meth)acrylate, 1,4-butanediol di(meth)acrylate, EO-modified 1,6-hexanediol di(meth)acrylate, ECH-modified 1,6-hexanediol di(meth)acrylate, allyloxy-polyethylene glycol acrylate, 1, 9-nonanediol di (meth) acrylate, EO-modified bisphenol A di(meth)acrylate, PO-modified bisphenol A di(meth)acrylate, modified bisphenol A di(meth)acrylate, EO-modified bisphenol F di(meth)acrylate, ECH-modified hexahydrophthalic acid diacrylate, hydroxypivalic acid neopentyl glycol di(meth)acrylate, neopentyl glycol di(meth)acrylate, EO-modified neopentyl glycol diacrylate, propyleneoxide (hereinafter referred to as "PO")-modified neopentyl glycol diacrylate, caprolactone-modified hydroxypivalate neopentyl glycol, stearic acid-modified pentaerythritol di(meth)acrylate, ECH-modified phthalic acid di(meth)acrylate, poly(ethylene glycol-tetramethylene glycol) di(meth)acrylate, poly(propylene glycol-tetramethylene glycol) di(meth)acrylate, polyester (di) acrylate, polyethylene glycol di(meth)acrylate, polypropylene glycol di (meth) acrylate, ECH-modified propylene glycol di(meth)acrylate, silicone di(meth)acrylate, triethylene glycol di(meth)acrylate, tetraethylene glycol di(meth)acrylate, dimethyloltricyclodecane di(meth)acrylate, neopentyl glycol-modified trimethylolpropane di(meth)acrylate, tripropylene glycol di(meth)acrylate, EO-modified tripropylene glycol di (meth) acrylate, triglycerol di(meth)acrylate, dipropylene glycol di(meth)acrylate, divinylethylene-urea, divinylpropylene-urea, *o*-, *m*-, or *p*-Xylylene di(meth)acrylate, 1,3-adamantane diacrylate, norbornane dimethanol diacrylate.

Of those, especially preferred for use in the invention are neopentyl glycol di(meth)acrylate, 1,9-nonanediol di(meth)acrylate, tripropylene glycol di(meth)acrylate, tetraethylene glycol di(meth)acrylate, hydroxypivalate neopentyl glycol di(meth)acrylate, polyethylene glycol di (meth) acrylate, *o*-, *m*-, or *p*-, benzene di (meth) acrylate, *o*-, *m*-, or *p*-xylylene di(meth)aclyate, etc.

Examples of the poly-functional polymerizable unsaturated monomer having at least three ethylenic unsaturated bond-having groups include ECH-modified glycerol tri(meth)acrylate, EO-modified glycerol tri(meth)acrylate, PO-modified glycerol tri(meth)acrylate, pentaerythritol triacrylate, EO-modified phosphoric acid triacrylate, trimethylolpropane tri(meth)acrylate, caprolactone-modified trimethylolpropane tri(meth)acrylate, EO-modified trimethylolpropane tri(meth)acrylate, PO-modified trimethylolpropane tri(meth)acrylate, tris(acryloxyethyl) isocyanurate, dipentaerythritol hexa(meth)acrylate, caprolactone-modified dipentaerythritol hexa(meth)acrylate, dipentaerythritol hydroxy-penta(meth)acrylate, alkyl-modified dipentaerythritol penta(meth)acrylate, dipentaerythritol poly(meth)acrylate, alkyl-modified dipentaerythritol tri(meth)acrylate, ditrimethylolpropane tetra(meth)acrylate, pentaerythritol ethoxy-tetra(meth)acrylate, pentaerythritol tetra(meth)acrylate, etc.

Of those, especially preferred for use in the invention are EO-modified glycerol tri(meth)acrylate, PO-modified glycerol tri(meth)acrylate, trimethylolpropane tri(meth)acrylate, EO-modified trimethylolpropane tri(meth)acrylate, PO-modified trimethylolpropane tri(meth)acrylate, dipentaerythritol hexa(meth)acrylate, pentaerythritol ethoxy-tetra(meth)acrylate, pentaerythritol tetra(meth)acrylate, etc.

Among the multi-functional polymerizable unsaturated monomers having two or more ethylenic unsaturated

bonds, multi-functional (meth)acrylate is preferably used from the viewpoint of photo-curability. The multi-functional (meth)acrylate herein is a general term for the bifunctional (meth)acrylate and tri-functional or higher valency of (meth)acrylates. Specific examples of multi-functional (meth)acrylate includes those found among the above-exemplified multi-functional polymerizable unsaturated monomer having two ethylenic unsaturated bonds, and those found among the above-exemplified multi-functional polymerizable unsaturated monomers having three or more ethylenic unsaturated bonds.

The oxirane ring-having compound (epoxy compound) includes, for example, polyglycidyl esters of polybasic acids, polyglycidyl ethers of polyalcohols, polyglycidyl ethers of polyoxyalkylene glycols, polyglycidyl ethers of aromatic polyols, hydrogenated polyglycidyl ethers of aromatic polyols, urethane-polyepoxy compounds, epoxidated polybutadienes, etc. One or more of these compounds may be used either singly or as combined.

The oxirane ring-having compounds preferred for use in the invention are exemplified by those disclosed at paragraph 0053 of JP-A 2009-73078.

Of those, especially preferred are bisphenol A diglycidyl ether, bisphenol F diglycidyl ether, hydrogenated bisphenol A diglycidyl ether, hydrogenated bisphenol F diglycidyl ether, 1,4-butanediol diglycidyl ether, 1,6-hexanediol diglycidyl ether, glycerin triglycidyl ether, trimethylolpropane triglycidyl ether, neopentyl glycol diglycidyl ether, polyethylene glycol diglycidyl ether, polypropylene glycol diglycidyl ether.

Commercial products favorable for use herein as the glycidyl group-having compound are exemplified by those disclosed at paragraph 0055 of JP-A 2009-73078. One or more of these may be used either singly or as combined.

The production method for the oxirane ring-having compounds is not specifically defined. For example, the compounds may be produced with reference to publications of Lecture of Experimental Chemistry 20, 4th Ed., Organic Synthesis II, p. 213, ff. (Maruzen, 1992); The chemistry of heterocyclic compounds - Small Ring Heterocycles, Part 3, Oxiranes (edited by Alfred Hasfner, John & Wiley and Sons, An Interscience Publication, New York, 1985); Yoshimura, Adhesive, Vol. 29, No. 12, 32, 1985; Yoshimura, Adhesive, Vol. 30, No. 5, 42, 1986; Yoshimura, Adhesive, Vol. 30, No. 7, 42, 1986; JP-A-11-100378, Japanese Patents 2906245 and 2926262.

As the polymerizable monomer for use in the invention, vinyl ether compounds also may be in the composition. Any known vinyl ether compounds are usable and are exemplified by those disclosed at paragraph 0057 of JP-A 2009-73078. The preferable vinyl ether compounds are mono-functional vinyl ether compounds such as cyclohexyl vinyl ether and 2-ethyl hexylvinylether; and poly-functional vinyl ether compounds such as diethylene glycol divinyl ether, 1,4-butanediol divinyl ether, trimethylene glycol trivinyl ether, cyclohexane dimethanol divinyl ether, nonanediol divinyl ether, and 1,3-benzenedimethanol divinyl ether.

These vinyl ether compounds can be produced, for example, according to the method described in Stephen. C. Lapin, Polymers Paint Colour Journal, 179 (4237), 321 (1988), concretely through reaction of a polyalcohol or a polyphenol with acetylene, or through reaction of a polyalcohol or a polyphenol with a halogenoalkyl vinyl ether. One or more of these compounds may be used either singly or as combined.

As the polymerizable monomer for use in the invention, styrene derivatives may also be employed. The styrene derivatives include, for example, styrene, *p*-methylstyrene, *p*-methoxystyrene, β-methylstyrene, *p*-methyl-β-methylstyrene, α-methylstyrene, *p*-methoxy-β-methylstyrene, p-hydroxystyrene, etc.

Polymerizable monomer adoptable to the present invention may be exemplified by those having at least either one of fluorine atom and silicon atom.

The curable composition of the present invention preferably contains polymerizable monomer compound having at least either one of fluorine atom and silicon atom.

The polymerizable monomer of the present invention, having at least either one of fluorine atom and silicon atom, may be understood as a compound having at least one group having fluorine atom, silicon atom, or both of fluorine atom and silicon atom, and at least one polymerizable functional group. The polymerizable functional group is preferably methacryloyl group, or epoxy group.

While content of the polymerizable monomer, having at least either one of fluorine atom and silicon atom, in the curable composition for imprints of the present invention is not specifically restricted, it is preferably 0.1 to 20% by mass of the total polymerizable monomer, preferably 0.2 to 15% by mass, more preferably 0.5 to 10% by mass, and particularly preferably 0.5 to 5% by mass, in view of improving curability and reducing viscosity of composition.

(1) Fluorine Atom-Containing Polymerizable Monomer

The fluorine atom-containing group owned by the fluorine atom-containing polymerizable monomer is preferably selected from fluoroalkyl group and fluoroalkyl ether group.

The fluoroalkyl group is preferably $C_{2-20}$ fluoroalkyl group, and more preferably $C_{4-8}$ fluoroalkyl group. Preferable examples of fluoroalkyl group include trifluoromethyl group, pentafluoroethyl group, heptafluoropropyl group, hexafluoroisopropyl group, nonafluorobutyl group, tridecafluorohexyl group, and heptadecafluorooctyl group.

In the present invention, the fluorine atom-containing polymerizable monomer preferably has a trifluoromethyl

group. By virtue of the trifluoromethyl group structure, the effects of the present invention may be expressed only with a small amount of addition (10% by mass or less, for example), so that compatibility with other components may be improved, line edge roughness after dry etching may be improved, and formability of repetitive pattern may be improved.

The fluoroalkyl ether group preferably has a trifluoromethyl group, similarly to the fluoroalkyl group, which may be exemplified by perfluoroethylenoxy group and perfluoropropyleneoxy group. Preferable examples are those having a fluoroalkyl ether unit having a trifluoromethyl group such as $-(CF(CF_3)CF_2O)-$, and/or those having a trifluoromethyl group at the terminal of the fluoroalkyl ether group.

The total number of fluorine atoms per one molecule, owned by the polymerizable monomer, having at least either one of fluorine atom and silicon atom, is preferably 6 to 60, more preferably 9 to 40, still more preferably 12 to 40, and particularly preferably 12 to 20.

The polymerizable monomer, having at least either one of fluorine atom and silicon atom, preferably has a fluorine content, defined below, of 20 to 60%, more preferably 30 to 60%, and still more preferably 35 to 60%. By adjusting the fluorine content in the appropriate range, the curable composition for imprints may be improved in the compatibility with other components, less causative of fouling on mold, improved in the line edge roughness after dry etching, and improved in the formability of repetitive pattern transfer. In this patent specification, the fluorine content is given by the equation below:

Fluorine content=[{(Number of fluorine atoms in polymerizable compound)×(atomic weight of fluorine atom)}/(molecular weight of polymerizable compound)]×100

As a preferable example of the fluorine atom-containing of polymerizable monomer, having at least either one of fluorine atom and silicon atom, a compound having a partial structure represented by formula (I) below may be exemplified. By adopting a compound having such partial structure, the curable composition for imprints having an excellent formability of pattern, even after repetitive pattern transfer, may be obtained, and temporal stability of the composition may be improved.

Formula (I) $-CH_2CH_2-C_nF_{2n+1}$

In formula (I), n represents an integer of 1 to 8, and preferably 4 to 6.

As another preferable example of the polymerizable monomer containing at least either one of fluorine atom and silicon atom, a compound having a partial structure represented by formula (II) below may be exemplified. Of course, the polymerizable monomer may have both of the partial structure represented by formula (I) and the partial structure represented by formula (II).

Formula (II)

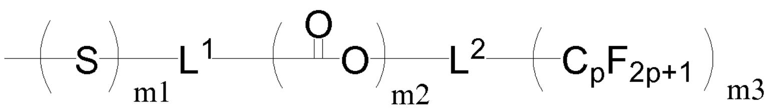

In formula (II), $L^1$ represents a single bond or a $C_{1-8}$ alkylene group, $L^2$ represents a $C_{1-8}$ alkylene group, each of m1 and m2 independently represents 0 or 1, and at least either one of m1 and m2 is 1. m3 represents an integer of 1 to 3, and p represents an integer of 1 to 8. When m3 represents 2 or larger integer, the individual $(-C_pF_{2p+1})$s may be same with, or different from each other.

It is preferable that each of $L^1$ and $L^2$ independently represents a $C_{1-4}$ alkylene group. The alkylene group may have a substituent without departing from the scope of the present invention. m3 is preferably 1 or 2. p is preferably an integer of 4 to 6.

Specific examples of the fluorine atom-containing polymerizable monomer used for the composition of the present invention will be enumerated, without restricting the present invention.

As the fluorine atom-containing polymerizable monomer, exemplified are fluorine atom-containing monofunctional polymerizable monomer such as trifluoroethyl (meth)acrylate, pentafluoroethyl (meth)acrylate, (perfluorobutyl) ethyl (meth)acrylate, perfluorobutyl-hydroxypropyl (meth)acrylate, (perfluorohexyl)ethyl (meth)acrylate, octafluoropentyl (meth)acrylate, perfluorooctylethyl (meth)acrylate, tetrafluoropropyl (meth)acrylate, and hexafluoropropyl (meth)acrylate. Also multi-functional polymerizable monomer having two or more polymerizable functional groups, such as those

having di(meth)acrylate structure having fluoroalkylene group, exemplified by 2,2,3,3,4,4-hexafluoropentane di(meth)acrylate and 2,2,3,3,4,4,5,5-octafluorohexane di(meth)acrylate, may be preferable examples of the fluorine atom-containing polymerizable monomer.

Also compounds having two or more fluorine-containing groups, such as fluoroalkyl group and fluoroalkyl ether group, in one molecule may preferably be used. More preferably, the compounds are such as those having at least two fluorine-containing groups selected from fluoroalkyl group and fluoroalkyl ether group, where at least two of the fluorine-containing group are brought apart while placing a $C_2$ or longer linking group in between.

The fluoroalkyl group preferably has two or more carbon atoms, and more preferably four or more carbon atoms. While the upper limit value of the number of carbon atoms is not specifically limited, it is preferably 20 or smaller, more preferably 8 or smaller, and still more preferably 6 or smaller. Fluoroalkyl group having 4 to 6 carbon atoms is most preferable. At least two of the fluoroalkyl groups preferably have a trifluoromethyl group structure. By containing a plurality of trifluoromethyl group structures, the curable composition exhibits the effects of the present invention even with a small amount of addition (for example, 10% by mass or less), so that compatibility with other components may be improved, and line edge roughness after dry etching may be improved.

From a similar point of view, also compounds having three or more trifluoromethyl groups in the polymerizable monomer (A) are preferable. More preferably, the compounds are those having 3 to 9, and more preferably 4 to 6, trifluoromethyl group structures. Prefeable examples of the compounds having three or more trifluoromethyl groups include those having a branched fluoroalkyl group which has two or more trifluoromethyl groups bound to a single fluorine-containing group, such as $-CH(CF_3)_2$, $-C(CF_3)_3$, and $-CCH_3(CF_3)_2CH_3$.

The fluoroalkyl ether group is preferably those having a trifluoromethyl group, exemplified by those having perfluoroethylenoxy group or perfluoropropyleneoxy group. Those having fluoroalkyl ether unit having a trifluoromethyl group such as $-(CF(CF_3)CF_2O)-$, and/or those having a trifluoromethyl group at the terminal of fluoroalkyl ether group, are preferable.

The total number of fluorine atoms per one molecule, owned by the polymerizable monomer (A), is preferably 6 to 60, more preferably 9 to 40, and still more preferably 12 to 40.

Fluorine content of the polymerizable monomer (A) is preferably 30 to 60%, more preferably 35 to 55%, and still more preferably 35 to 50%. By adjusting the fluorine content to the appropriate range, fouling on mold may be reduced, and line edge roughness after dry etching may be improved.

At least two of the fluorine-containing groups owned by the polymerizable monomer (A) may preferably be brought apart while placing a $C_2$ or longer linking group in between. In other words, for the case where the polymerizable monomer (A) has two or more fluorine-containing groups, two such fluorine-containing group are brought apart while placing a $C_2$ or longer linking group in between. For the case where the polymerizable monomer (A) has three or more fluorine-containing groups, at least two of them are brought apart while placing a $C_2$ or longer linking group in between, while allowing arbitrary mode of binding for the residual fluorine-containing groups. The $C_2$ or longer linking group herein is a linking group having at least two carbon atoms not substituted by fluorine atoms.

Functional groups possibly contained in the $C_2$ or longer linking group include groups having at least one of alkylene group, ester group, sulfide group, arylene group, amide group and urethane group, wherein at least ester group and/or sulfide group may preferably be contained. The $C_2$ or longer linking group is preferably selected from alkylene group, ester group, sulfide group, arylene group, amide group, urethane group and combinations of these groups.

These groups may have a substitutive group, without departing from the spirit of the present invention.

A preferable example of the polymerizable monomer (A) may be exemplified by a compound represented by formula (A1) below.

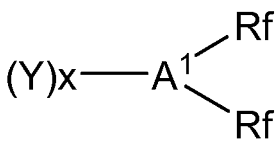 (A1)

In formula (A1), Rf represents a functional group having a fluorine-containing group selected from fluoroalkyl group and fluoroalkyl ether group, and $A^1$ represents a linking group. Y represents a polymerizable functional group, and preferably represents a (meth)acryl ester group, epoxy group, or vinyl ether group. x represents an integer of 1 to 4, and preferably represents 1 or 2. If x is 2 or larger, the individual (Y)s may be same with, or different from each other.

$A^1$ preferably represents a linking group having an alkylene group and/or arylene group, and may additionally have a linking group which contains a hetero atom. The linking group having a hetero atom may be exemplified by -O-, -C (=O) O-, -S-, -C(=O)-, and -NH-. While the groups may have a substituent without departing from the spirit of the present invention, no substitution is more preferable. $A^1$ is preferably a $C_{2-50}$ linking group, and more preferably $Z_{4-15}$ linking group.

Preferable examples of the polymerizable monomer (A) may be given by compounds having a partial structure represented by formula (I) below. By adopting the compounds having this fort of partial structure, the pattern formability may be improved, and temporal stability of the composition may be improved.

$$-CH_2CH_2-C_nF_{2n+1} \qquad (I)$$

In formula (I), n represents an integer of 1 to 8, preferably 4 to 6.

Other preferable examples of the polymerizable monomer (A) may be given by compounds having a partial structure represented by formula (II) below. Of course, the polymerizable monomer (A) may have both of partial structures represented by formulae (I) and (II).

$$-\left(S\right)_{m1}R^2-\left(\overset{O}{\overset{\|}{C}}O\right)_{m2}R^3-\left(C_nF_{2n+1}\right)_{m3} \qquad (II)$$

In formula (II), each of $R^2$ and $R^3$ independently represents a $C_{1-8}$ alkylene group, and preferably a $C_{1-4}$ alkylene group. The alkylene group may have a substituent, without departing from the spirit of the present invention.

Each of m1 and m2 independently represents 0 or 1, where at least either one of m1 and m2 is 1. m3 represents an integer of 1 to 3, preferably 1 or 2. n represents an integer of 1 to 8, preferably 4 to 6. If m3 is 2 or larger, the individual $(-C_nF_{2n+1})$s may be same with, or different from each other.

The polymerizable monomer (A) is preferably a polymerizable monomer represented by formula (III) below.

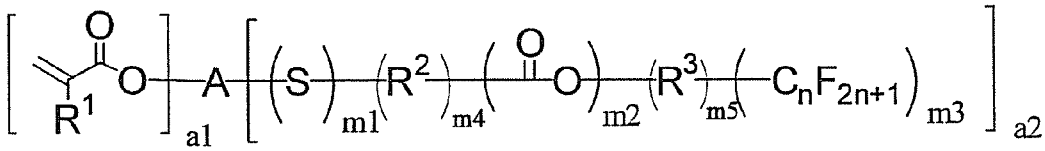

(III)

(In formula (III), $R^1$ represents a hydrogen atom, alkyl group, halogen atom or cyano group, A represents an (a1+a2)-valent linking group, and a1 represents an integer of 1 to 6. a2 represents an integer of 2 to 6, and each of $R^2$ and $R^3$ independently represents a $C_{1-8}$ alkylene group. Each of m1 and m2 independently represents 0 or 1, and at least either one of m1 and m2 is 1. m3 represents an integer of 1 to 3. Each of m4 and m5 independently represents 0 or 1, at least either one of m4 and m5 is 1, and m4 represents 1 if both of m1 and m2 are 1. n represents an integer of 1 to 8.)

$R^1$ represents a hydrogen atom, alkyl group, halogen atom or cyano group, preferably hydrogen atom or alkyl group, more preferably hydrogen atom or methyl group, and still more preferably hydrogen atom.

"A" represents an (a1+a2)-valent linking group, preferably a linking group which has an alkylene group and/or arylene group, and may additionally have a hetero atom-containing linking group. The hetero atom-containing linking group may be exemplified by -O-, -C(=O)O-, -S-, -C(=O)-, and-NH-. These groups may have substituents without departing from the scope of the present invention, but more preferably have no substituents. "A" is preferably $C_{2-50}$ group, and more preferably $C_{4-15}$ group.

$R^2$, $R^3$, m1, m2, m3 and n are similarly defined as those in formula (II), also with the same preferable ranges.

a1 represents an integer of 1 to 6, preferably 1 to 3, and more preferably 1 or 2.

a2 represents an integer of 2 to 6, preferably 2 or 3, and more preferably 2.

If a1 is 2, the individual (A)s may be same with, or different from each other.

If a2 is 2 or larger, each of $R^2$, $R^3$, m1, m2, m3, m4, m5 and n may be same with, or different from each other.

Molecular weight of the polymerizable monomer (A) used in the present invention is preferably 500 to 2, 000, preferably 600 to 1,500, and more preferably 600 to 1,200.

Specific examples of the polymerizable monomer (A) used for the curable composition for imprints of the present invention will be given below, without restricting the present invention. $R^1$ in the formulae below represents any of hydrogen atom, alkyl group, halogen atom and cyano group.

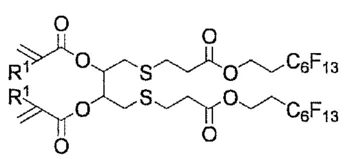

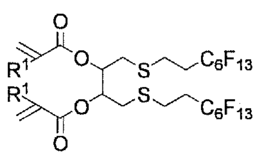

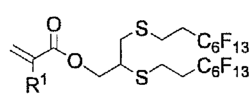

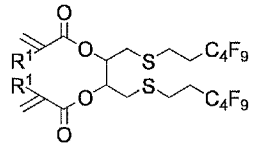 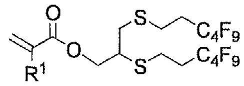 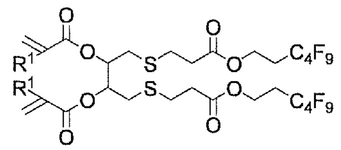

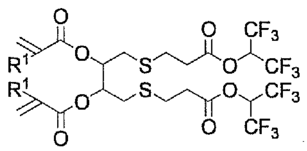 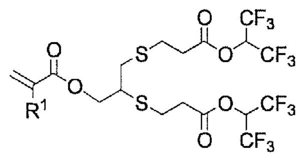 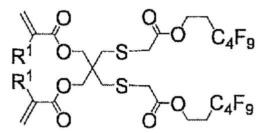

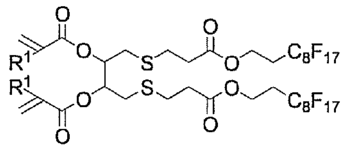 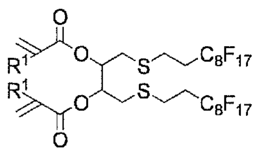 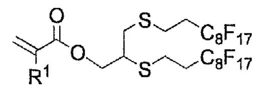

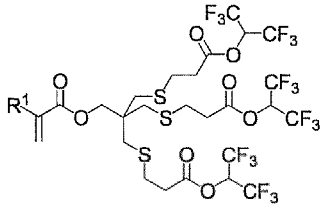 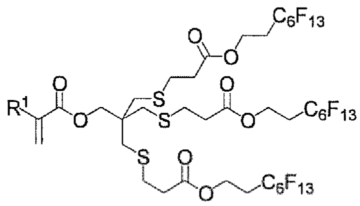 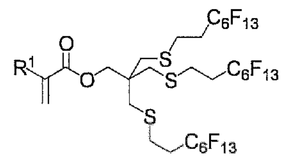

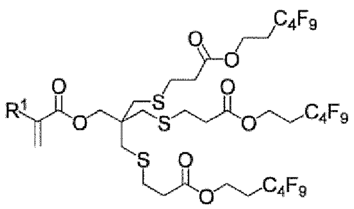 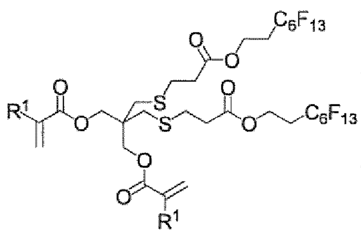 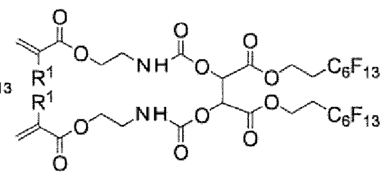

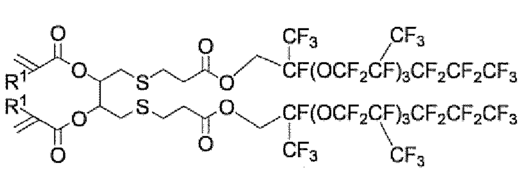 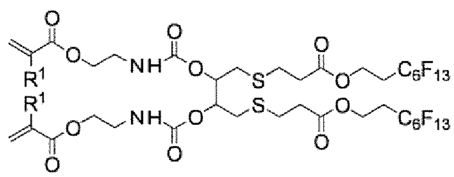

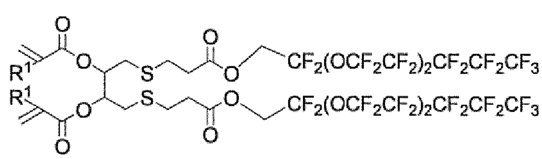 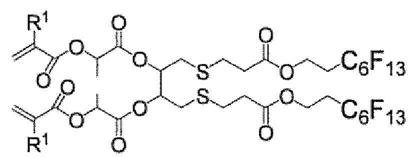

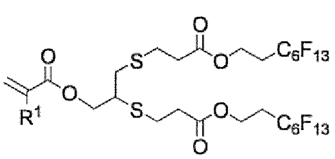 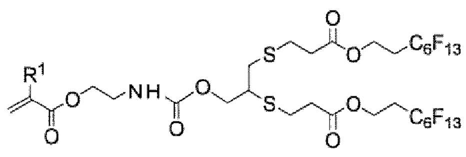

(2) Polymerizable Monomer Having Silicon Atom

The silicon atom-containing functional group owned by the silicon atom-containing polymerizable monomer

may be exemplified by trialkyl silyl group, chain-like siloxane structure, cyclic siloxane structure, and basket-like siloxane structure. From the viewpoint of compatibility with other components and mold-releasing property, the functional group having a trimethylsilyl group or methylsiloxane structure is preferable.

The silicon atom-containing polymerizable monomer may be exemplified by 3-tris(trimethylsilyloxy)silylpropyl (meth)acrylate, trimethylsilylethyl (meth)acrylate, (meth)acryloxymethylbis(trimethylsiloxy)methylsilane, (meth)acryloxymethyltris(trimethylsiloxy)silane, 3-(meth)acryloxypropylbis(trimethylsiloxy)methylsilane, and polysiloxane having a (meth)acryloyl group at the terminal or in side chain (for example, X-22-164, X-22-174DX, X-22-2426 and X-22-2475 Series from Shin-Etsu Chemical Co., Ltd.).

Besides them, the polymerizable monomers adoptable to the present invention include propenyl ether and butenyl ether. The propenyl ether and butenyl ether may be exemplified by 1-dodecyl-1-propenyl ether, 1-dodecyl-1-butenyl ether, 1-butenoxymethyl-2-norbornene, 1-4-di(1-butenoxy)butane, 1,10-di(1-butenoxy)decane, 1,4-di(1-butenoxymethyl) cyclohexane, diethylene glycol di(1-butenyl) ether, 1,2,3-tri(1-butenoxy)propane, and propenyl ether propylene carbonate.

Among these polymerizable monomers, (meth)acrylate compound is preferable as the polymerizable monomer (A), from the viewpoint of viscosity of composition and photo-curability, and acrylate is more preferable. In the present invention, multi-functional polymerizable monomer having two or more polymerizable functional groups is preferable.

In the present invention, ratio of mixing of monofunctional (meth)acrylate compound and multi-functional (meth)acrylate compound is particularly preferably 80/20 to 0/100 on the weight basis, more preferably 70/30 to 0/100, and still more preferably 40/60 to 0/100. By selecting an appropriate ratio, the composition will have a sufficient level of curability, and low viscosity.

In the multi-functional (meth)acrylate compound, ratio of the bifunctional (meth)acrylate and the (meth)acrylate having three or higher degree of functionality is preferably 100/0 to 20/80 on the mass basis, more preferably 100/0 to 50/50, and still more preferably 100/0 to 70/30. Since the (meth)acrylate having three or higher degree of functionality has viscosity larger than that of the bifunctional (meth)acrylate, so that the curable composition for imprints of the present invention, having larger content of bifunctional (meth) acrylate, may be more preferable in view of reducing the viscosity.

The polymerizable monomer (A) component preferably contains a polymerizable monomer having an aromatic structure and/or alicyclic hydrocarbon structure, in view of improving dry etching resistivity and line edge roughness after dry etching. The polymerizable monomer (A) component preferably contains 50% by mass or more, and more preferably 80% by mass or more, of polymerizable monomer having an aromatic structure and/or alicyclic hydrocarbon structure. The polymerizable monomer having an aromatic structure is preferably a (meth)acrylate compound having an aromatic structure.

As the polymerizable monomer compound having an aromatic structure is preferably a mono-functional (meth)acrylate compound represented by the formula (I) or a poly-functional (meth)acrylate compound represented by the formula (II) as mentioned below.

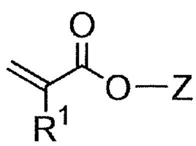

(I)

wherein Z is a group having an aromatic group; $R^1$ represents a hydrogen atom, an alkyl group, or a halogen atom; and, when the polymerizable monomer (Ax) is liquid at 25°C, the polymerizable monomer (Ax) has a viscosity of 500 mPa•s or less.

$R^1$ is preferably a hydrogen atom, or an alkyl group, more preferably a hydrogen atom, or a methyl group, further more preferably a hydrogen atom from the viewpoint of the curability of the composition. Examples of the halogen atom include fluorine atom, chlorine atom, bromine atom, and iodine atom, and preferred is fluorine atom.

Z is an aralkyl group which may have a substituent, an aryl group which may have a substituent, or a group in which those groups are bonded to each other via a linking group. The linking group may include a hetero atom. The linking group is preferably $-CH_2-$, -O-, -C(=O)-, -S-, or a combination thereof. The aromatic group contained in Z is preferably a phenyl group or a naphthyl group. The molecular weight of Z is preferably 90 to 300, more preferably 120 to 250.

When the polymerizable monomer (Ax) is liquid at 25°C, the viscosity thereof is preferably 2 to 500 mPa•s at 25°C, more preferably 3 to 200 mPa•s, further more preferably 3 to 100 mPa• s. The polymerizable monmer (Ax) is preferably liquid at 25°C, or solid having a melting point of 60°C or less, more preferably a melting point of 40°C or less, further more preferably liquid at 25°C, or solid having a melting point of 25°C or less.

Z preferably represents $-Z^1-Z^2$. $Z^1$ is a single bond, or a hydrocarbon group which may have a linking group containing a hetero atom in the chain thereof. $Z^2$ is an aromatic group which may have a substituent. $Z^2$ has a molecular

weight of 90 or more.

$Z^1$ is preferably a single bond, or an alkylene group which may have a linking group containing a hetero atom in the chain of the linking group. $Z^1$ is more preferably an alkylene group not having a linking group containing a hetero atom in the chain thereof, more preferably a methylene group, or an ethylene group. Examples of the linking group containing a hetero atom include -O-, -C(=O)-, -S-, and a combination of an alkylene group and at least one of -O-, -C(=O)- and -S-. The number of the carbon atoms of $Z^1$ is preferably 1 to 3.

$Z^2$ is also preferably a group in which two or more aromatic groups directly bond to each other, or a group in which two or more aromatic groups bond to each other via a linking group. The linking group is preferably $-CH_2-$,-O-, -C(=O)-, -S-, or a combination thereof.

Examples of a substituent which the aromatic group may have include a halogen atom (fluorine atom, chlorine atom, bromo atom, iodine atom), a linear, a branched, or a cyclic alkyl group, an alkenyl group, an alkynyl group, an aryl group, an acyl group, an alkoxycarbonyl group, an aryloxycarbonyl group, a carbamoyl group, a cyano group, a carboxyl group, a hydroxy group, an alkoxy group, an aryloxy group, an alkylthio group, an arylthio group, a heterocyclic-oxy group, an acyloxy group, an amino group, a nitro group, a hydrazino group, a heterocyclic group. A group which is substituted with those groups is also preferred.

The amount of the compound represented by the formula (I) to be added in the composition is preferably 10 to 100% by mass, more preferably 20 to 100% by mass, further more preferably 30 to 80% by mass.

Of the compounds represented by the formula (I), specific examples of the compounds not having a substituent on the aromatic ring include benzyl (meth)acrylate, phenethyl (meth)acrylate, phenoxyethyl (meth)acrylate, 1- or 2-naphtyl (meth)acrylate, 1- or 2-naphtylmethyl (meth)acrylate, and 1- or 2- naphthylethyl (meth)acrylate.

The compound represented by the formula (I) is also preferably represented by the following formula (II);

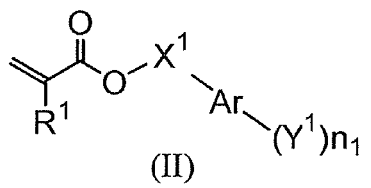

(II)

wherein $R^1$ represents a hydrogen atom, an alkyl group, or a halogen atom; $X^1$ is a single bond, or a hydrocarbon group which may have a linking group containing a hetero atom in the chain of the linking group; $Y^1$ represents a substituent having a molecular weight of 15 or more; n1 represents an integer of 1 to 3; and Ar is an aromatic linking group, preferably a phenylene group, and an aromatic group.

$R^1$ is the same as $R^1$ in the above formula (I) and the preferable range thereof is the same as $R^1$ in the above formula (I).

$X^1$ is the same as $Z^1$ in the above and the preferable range thereof is the same as $Z^1$ in the above. $Y^1$ is a substituent having a molecular weight of 15 or more. Examples of $Y^1$ include an alkyl group, an alkoxy group, an aryloxy group, an alkenyl group, an aralkyl group, an acyl group, an alkoxycarbonyl group, an alkylthio group, an arylthio group, a halogen atom and a cyano group. Those substituents may have a substituent.

When n1 is 2, $X^1$ is preferably a hydrocarbon group having 1 carbon atom.

In particular, the more preferred embodiment is that n1 is 1 and $X^1$ is an alkylene group having 1 to 3 carbon atoms.

The compound represented by the formula (II) is more preferably represented by the following formula (IV) or the following formula (V);

The compound represented by the formula (IV);

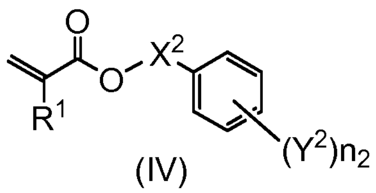

(IV)

wherein $R^1$ represents a hydrogen atom, an alkyl group, or a halogen atom; $X^2$ is a single bond, or a hydrocarbon group which may have a linking group containing a hetero atom in the chain of the linking group; $Y^2$ represents a substituent having a molecular weight of 15 or more, the substituent being other than an aromatic group-containing group; n2 represents an integer of 1 to 3.

$R^1$ is the same as $R^1$ in the above formula (I) and the preferable range thereof is the same as $R^1$ in the above formula (I).

When $X^2$ is a hydrocarbon group, $X^2$ is preferably a hydrocarbon group having 1 to 3 carbon atoms, more preferably a substituted or unsubstituted alkylene group having 1 to 3 carbon atoms, further more preferably an unsubstituted alkylene group having 1 to 3 carbon atoms, still more preferably an ethylene group. By applying such a hydrocarbon group, it makes possible to provide a composition having lower viscosity and lower volatility.

$Y^2$ represents a substituent which has a molecular weight of 15 or more and the substituent is not an aromatic group-containing group. The upper limit of the molecular weight of $Y^2$ is preferably 150 or less. Examples of $Y^2$ include an alkyl group having 1 to 6 carbon atoms such as methyl group, ethyl group, isopropyl group, tert-butyl group, and cyclohexyl group, an alkenyl group having 1 to 6 carbon atoms such as an allyl group, a halogen atom such as chlorine atom and bromo atom, and an alkoxy group having 1 to 6 carbon atoms such as methoxy group, ethoxy group, and cyclohexyloxy group.

n2 is preferably an integer of 1 or 2. When n2 is 1, the substituent $Y^2$ is preferably at para-position in the compound. When n2 is 2, $X^2$ is preferably a single bond, or a hydrocarbon group having one carbon atom from the viewpoints of the viscosity of the composition.

The molecular weight of the (meth)acrylate represented by the formula (IV) is preferably 175 to 250, more preferably 185 to 245 from the viewpoint of attainment of the low viscosity and the low volatility.

The viscosity at 25°C of the (meth)acrylate represented by the formula (IV) is preferably 50 mPa•s or less, more preferably 20 mPa•s or less.

In addition, the compound represented by the formula (IV) preferably is used for a reaction diluent.

The amount of the compound represented by the formula (IV) to be added is preferably 10% by mass or more, more preferably 15% by mass or more, further more preferably 20% by mass or more from the viewpoint of the viscosity of the composition and the pattern accuracy of the cured film. While the amount thereof to be added is preferably 95% by mass or less, more preferably 90% by mass or less, further more preferably 85% by mass or less from the viewpoint of the tackiness of the cured film and the mechanical strength of the cured film.

Specific examples of the compounds represented by Formula (IV) are shown below, to which, however, the present invention should not be limited.

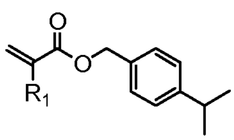
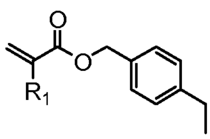
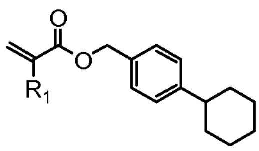
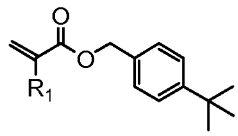
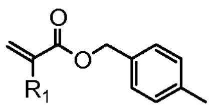
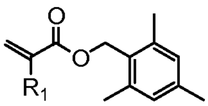
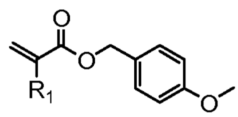
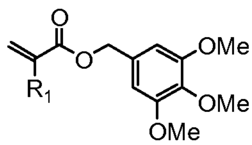
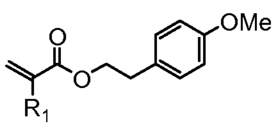
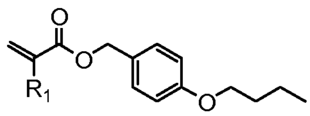
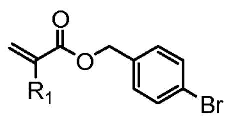
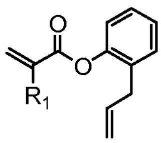
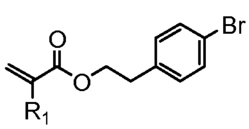
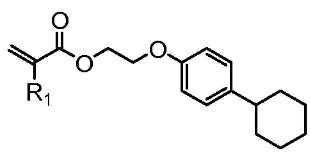
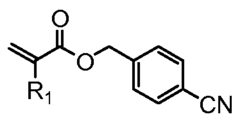
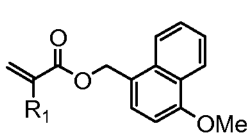
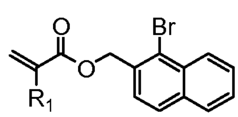

The compound represented by the formula (V);

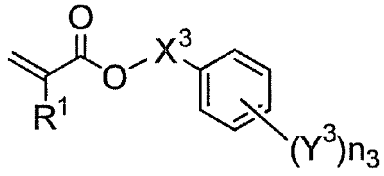

(V)

wherein $R^1$ represents a hydrogen atom, an alkyl group, or a halogen atom; $X^3$ is a single bond, or a hydrocarbon group which may have a linking group containing a hetero atom in the chain of the linking group; $Y^3$ represents a substituent having an aromatic group and having a molecular weight of 15 or more; and n3 represents an integer of 1 to 3.

$R^1$ is the same as $R^1$ in the above formula (I) and the preferable range thereof is the same as $R^1$ in the above formula (I).

$Y^3$ represents a substituent having an aromatic group, and a preferred embodiment of the substituent having an aromatic group is the embodiment that an aromatic group bonds to the aromatic ring in the formula (V) directly, or via a linking group. Preferred example of the linking group thereof include an alkylene group, a linking group containing a hetero atom (preferably -O-, -S-, -C(=O)O-) and a combination thereof. Among them, an alkylene group, -O- and a combination thereof is more preferable. Embodiment in which a phenyl group bonds to the aromatic ring in the formula (V) directly, or via the above mentioned linking group is preferable. The substituent is preferably a phenyl group, a benzyl group, a phenoxy group, a benzyloxy group or a phenylthio group. The molecular weight of $Y^3$ is preferably 230 to 350.

n3 is preferably 1 or 2, more preferably 1.

The amount of the compound represented by the formula (V) to be added is preferably 10% by mass or more, more preferably 20% by mass or more, further more preferably 30% by mass or more. On the other hand, the amount thereof is preferably 90% by mass or less, more preferably 80% by mass or less, further more preferably 70% by mass, from the viewpoint of the tackiness and mechanical strength of the cured film.

Specific examples of the compounds represented by Formula (V) are shown below, to which, however, the present invention should not be limited.

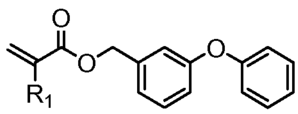
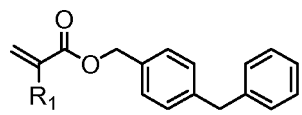
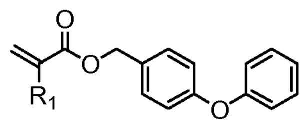

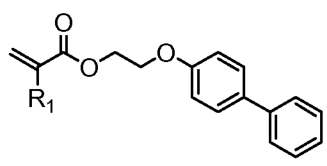
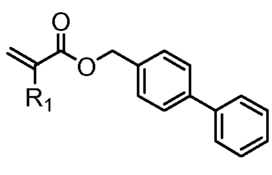
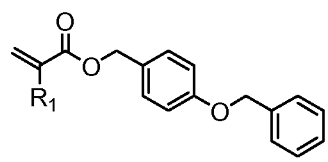

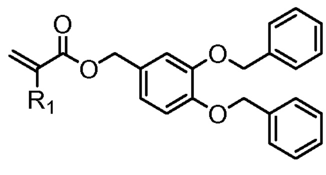

The (meth)acrylate compound represented by the following formula (II).

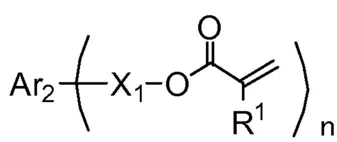

wherein $Ar_2$ represents a n-valued linking group having an aromatic group, preferably phenylene group. $X_1$ and $R^1$ are the same as $X_1$ and $R^1$ in the above, respectively. n represents an integer of 1 to 3, preferably 1.

The compound represented by the formula (II) is preferably the compound represented by the formula (VI) or the formula (VIII).
The compound represented by the formula (VI);

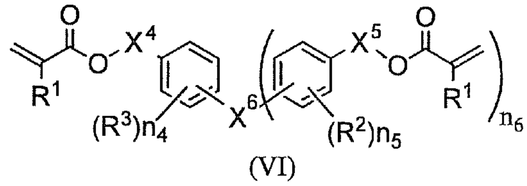

(VI)

wherein $X^6$ is a (n6 + 1)-valent linking group; $R^1$ each are a hydrogen atom, an alkyl group, or a halogen atom; $R^2$ and $R^3$ each are a substituent; n4 and n5 each are an integer of 0 to 4; n6 is 1 or 2; and $X^4$ and $X^5$ each are a hydrocarbon group which may have a linking group containing a hetero atom in the chain of the linking group.
$X^6$ is a (n6 + 1)-valent linking group, preferably an alkylene group, -O-, -S-, -C(=O)O-, or a linking group consisting of a combination of two or more thereof. The alkylene group is preferably an alkylene group having 1 to 8 carbon atoms, more preferably an alkylene group having 1 to 3 carbon atoms. Also, the alkylene group is preferable an unsubstituted alkylene group.
n6 is preferably 1. When n6 is 2, the plural $R^1$, $X^5$ and $R^2$ existing in the formula may be the same or different.
$X^4$ and $X^5$ each are an alkylene group not having a linking group, more preferably an alkylene group having 1 to 5 carbon atoms, further more preferably an alkylene group having 1 to 3 carbon atoms, still more preferably a methylene group.
$R^1$ is the same as $R^1$ in the above formula (I) and the preferable range thereof is the same as $R^1$ in the above formula (I).
$R^2$ and $R^3$ each represent a substituent, preferably an alkyl group, a halogen atom, an alkoxy group, an acyl group, an acyloxy group, an alkoxycarbonyl group, a cyano group, a nitro group. The alkyl group is preferably an alkyl group having 1 to 8 carbon atoms. The halogen atom is exemplified by fluorine atom, chlorine atom, bromine atom and iodine atom, and is preferably fluorine atom. The alkoxy group is preferably an alkoxy group having 1 to 8 carbon atoms. The acyl group is preferably an acyl group having 1 to 8 carbon atoms. The acyloxy group is preferably an acyloxy group having 1 to 8 carbon atoms. The alkoxycarbonyl group is preferably an alkoxycarbonyl group having 1 to 8 carbon atoms.
n4 and n5 each are an integer of 0 to 4. When n4 or n5 is two or more, the plural $R^2$ and $R^3$ existing in the formula may be the same or different.
The compound represented by the formula (VI) is preferably a compound represented by the formula (VII);

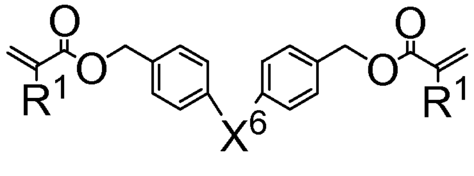

wherein $X^6$ represents an alkylene group, -O-, -S-, or a linking group which is combined with two or more thereof; $R^1$ each are a hydrogen atom, an alkyl group, or a halogen atom.
$R^1$ is the same as $R^1$ in the above formula (I) and the preferable range thereof is the same as $R^1$ in the above formula (I).
When $X^6$ is an alkylene group, the alkylene group is preferably an alkylene group having 1 to 8 carbon atoms, more preferably an alkylene group having 1 to 3 carbon atoms. The alkylene group is preferably an unsubstituted alkylene group.
$X^6$ is preferably $-CH_2-$, $-CH_2CH_2-$, -O-, or -S-.
The amount of the compound represented by the formula (VI) to be contained in the composition of the present invention is not defined. However, the content relative to the total amount of the polymerizable monomers is preferably 1 to 100% by mass, more preferably 5 to 70% by mass, further more preferably 10 to 50% by mass from the viewpoint of the curability and the viscosity of the composition.
Specific examples of the compounds represented by Formula (VI) are shown below, to which, however, the present invention should not be limited, wherein $R^1$ in the following is the same as $R^1$ in the above formula (VI), the preferable range thereof is the same as $R^1$ in the above formula (VI). The $R^1$ is more preferably a hydrogen atom.

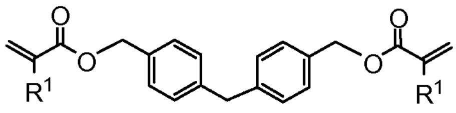

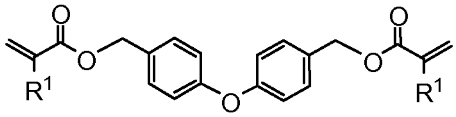

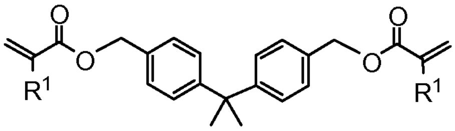

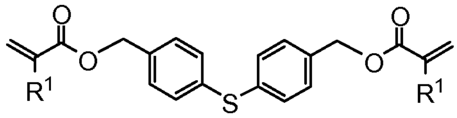

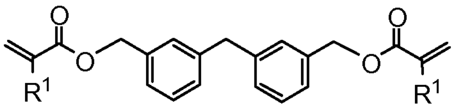

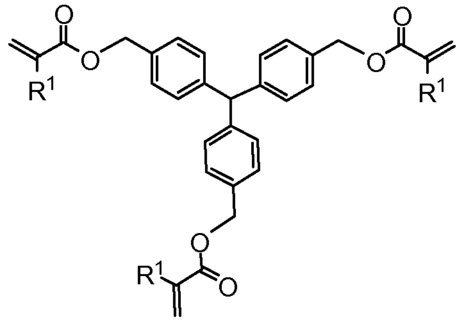

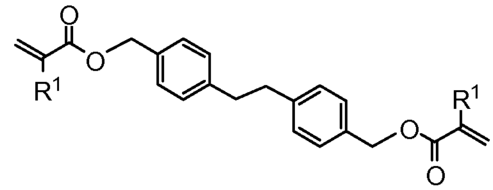

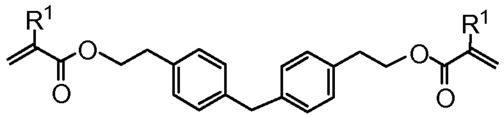

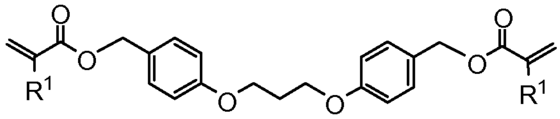

The polymerizable monomer represented by the formula (VIII)

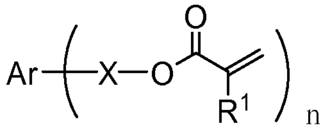

(VIII)

wherein Ar is an arylene group which may have a substituent, X is a single bond or an organic linking group, $R^1$ is hydrogen atom or methyl group, and n is 2 or 3.

In the formula, the above arylene group is exemplified by a hydrocarbon arylene group such as phenylene group and naphthylene group and a heteroarylene group which is a crosslinking group derived from indole or carbazole, and is preferably phenylene group from the viewpoints of the viscosity and the etching resistance. The above arylene group may have a substituent, and examples of the preferable substituent thereof include an alkyl group, an alkoxy group, hydroxy group, an alkoxycarbonyl group, an amide group, and a sulfone amide group.

The organic linking group in the above X is exemplified by an alkylene group, an arylene group and an aralkylene group which may include a hetero atom in the chain. Of those, preferred are an alkylene group and an arylene group, more preferred is an alkylene group. The above X is particularly preferably a single bond or an alkylene.

The above $R^1$ is hydrogen atom or methyl group, preferably hydrogen atom.

n is 2 or 3, preferably 2.

The polymerizable monomer (VIII) is preferably the following formula (I-a) or the following formula (I-b) from the viewpoint of reduction of the viscosity of the composition.

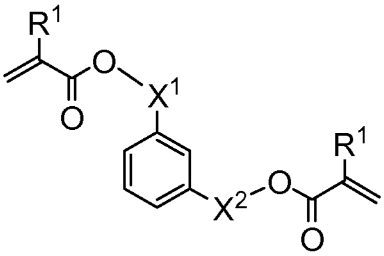

(I − a)

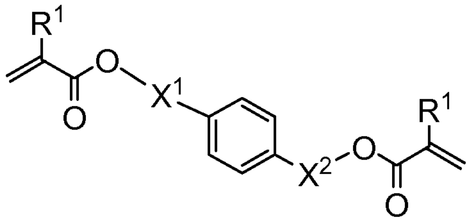

(I − b)

wherein $X^1$ and $X^2$ each independently are a single bond or an alkylene group which may have a substituent having 1 to 3 carbon atoms, $R^1$ is hydrogen atom or methyl group.

In the formula (I-a), the above $X^1$ is preferably a single bond or methylene group, more preferably methylene group from the viewpoint of reduction of the viscosity.

The preferred range of the above $X^2$ is the same as the above $X^1$.

The above $R^1$ is the same as $R^1$ in the above formula (VIII) and the preferred range is also the same.

The above polymerizable monomer is preferably liquid at 25°C since liquid can control occurring foreign substance if the amount to be added thereof is increased.

Specific examples of the polymerizable monomer represented by the formula (VIII) are shown below. $R^1$ is the same as $R^1$ in the formula (VIII) and represents hydrogen atom or methyl group. The present invention is not limited thereto.

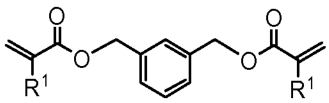
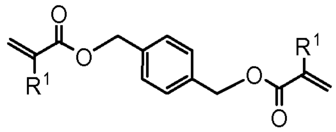
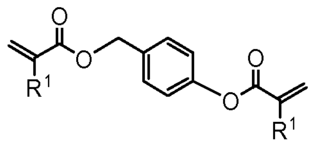

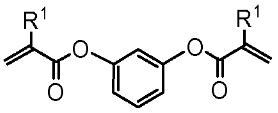
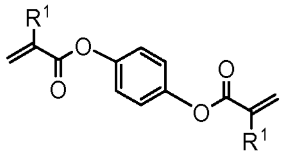
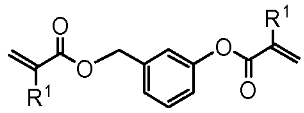

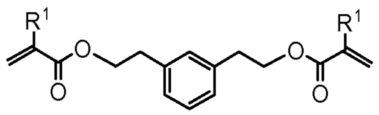
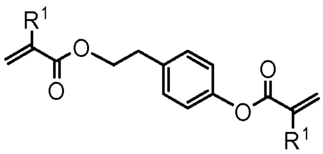
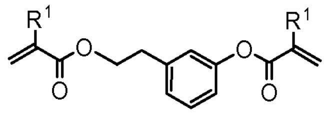

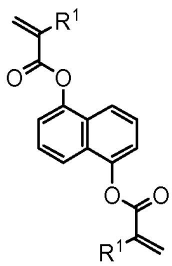
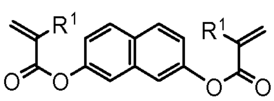
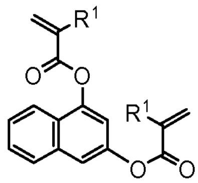
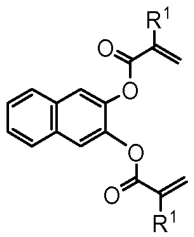
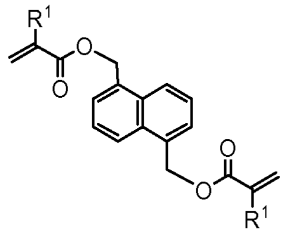

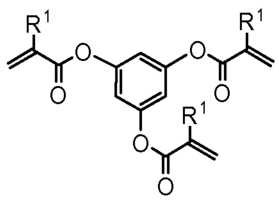
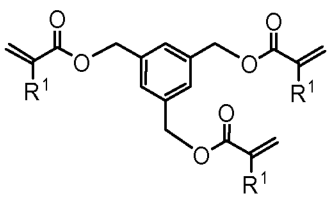

Particularly preferable examples of the (meth)acrylate compound having an aromatic structure include monofunctional (meth)acrylate compounds having a naphthalene structure, such as 1- or 2-naphthyl (meth)acrylate, 1- or 2-naphthylmethyl (meth)acrylate, and 1- or 2-naphthylethyl (meth)acrylate; monofunctional acrylates having a substituent on an aromatic ring, such as benzyl acrylate; and bifunctional acrylates such as catechol diacrylate, and xylylene glycol diacrylate. Preferable examples of the polymerizable monomer having an alicyclic hydrocarbon structure include isobornyl (meth)acrylate, dicyclopentanyl (meth)acrylate, dicyclopentanyl oxyethyl (meth)acrylate, dicyclopentenyl (meth)acrylate, adamantyl (meth)acrylate, tricyclodecanyl (meth)acrylate, and tetracyclododecanyl (meth)acrylate.

For the case where (meth)acrylate is used as the polymerizable monomer (A), acrylate is preferred over methacrylate.

Total content of the polymerizable monomer (A) in the curable composition for imprints of the present invention, excluding the solvent, is preferably 50 to 99.5% by mass, more preferably 70 to 99% by mass, and particularly preferably 90 to 99% by mass, in view of improving the curability, and improving viscosity of the curable composition for imprints of the present invention.

In the curable composition for imprints of the present invention, it is preferable that the content of polymerizable monomer having a viscosity at 25°C of 3 to 100 mPa ▪ s accounts for 80% by mass or more of the total polymerizable monomer (A) component, it is more preferable that the content of polymerizable monomer having a viscosity of 3 to 70 mPa ▪ s accounts for 80% by mass or more, it is still more preferable that the content of polymerizable monomer having a viscosity of 7 to 50 mPa ▪ s accounts for 80% by mass or more, and it is most preferable that the amount of polymerizable monomer having a viscosity of 8 to 30 mPa ▪ s accounts for 80% by mass or more.

The viscosity of the curable composition for imprints of the present invention at 25°C is preferably 5 to 50 mPa ▪ s, more preferably 6 to 40 mPa ▪ s, still more preferably 7 to 30 mPa ▪ s, and most preferably 8 to 25mPa ▪ s. By adjusting the viscosity of composition to 5 to 50 mPa ▪ s, the mold filling performance may be improved, and square pattern profile may more readily be obtained even under low mold stamping pressure in the process of imprint. The method of the present invention expresses distinctive effects particularly when a low-viscosity polymerizable monomer is used.

In the polymerizable monomer (A) contained in the curable composition for imprints of the present invention, a polymerizable monomer which exists in a form of liquid at 25°C preferably accounts for 50% by mass or more of the total polymerizable monomer, from the viewpoint of temporal stability.

The present invention also includes a method of manufacturing a curable composition for imprints, which includes a method of manufacturing a polymerizable monomer for imprint, which includes a step of removing a polymer impurity containing the polymerizable monomer (A) as a repeating unit; and a curable composition for imprints, which contains the polymerizable monomer manufactured by the above-described method of manufacturing a polymerizable monomer for imprint.

While a wide variety of publicly-known methods may be adoptable to the process of removing the polymer containing the polymerizable monomer (A) as a repeating unit, from the polymerizable monomer composition which contains the polymerizable monomer (A) and the polymer containing the polymerizable monomer (A) as a repeating unit, the method of the invention includes a step of mixing a solvent capable of dissolving at least one species of the polymerizable monomer (A), but incapable of, or nearly incapable of dissolving the polymer containing the polymerizable monomer (A) as a repeating unit, with the polymerizable monomer (A) composition; and allowing the polymer to deposit. Preferable examples of the solvent incapable of, or nearly incapable of dissolving the polymer containing the polymerizable monomer (A) composition as a repeating unit include those containing hydrocarbon solvent (pentane, hexane, heptane, toluene, xylene, and benzene, for example), and alcoholic solvent (methanol, ethanol, 1- or 2-propanol, and 1- or 2-butanol, for example). Concentration of the polymerizable monomer composition to be mixed is preferably 1 to 99% by mass, more preferably 3 to 50% by mass, still more preferably 5 to 30% by mass, and most preferably 5 to 20% by mass.

The step of allowing the polymer to deposit is generally followed by removal of the deposited polymer. Method of removal is preferably filtration. Preferable examples of filtering medium include filter paper, filter, silica gel, alumina and celite, among which filter is preferable. Preferable materials for composing the filter include polytetrafluoroethylene, polyethylene, nylon and so forth. Pore size of the filter is preferably 0.005 μm to 10 μm, and more preferably 0.01 μm to 1 μm.

The polymerizable monomer (A), after being separated from the deposited polymer, is then added to the curable composition for imprints, in a form of the resultant solution without further treatment, or after condensation or replacement of solvent. In the present invention, a polymerization inhibitor is added in the manufacturing process of the polymerizable monomer, wherein it is more preferable to add it in the preceding stage of condensation.

The polymerization inhibitor may be exemplified by hydroquinone, *p*-methoxyphenol, di-*tert*-butyl-*p*-cresol, pyrogallol, tert-butylcatechol, benzoquinone, 4,4'-thiobis(3-methyl-6-*tert*-butylphenol), 2,2'-methylenebis(4-methyl-6-*tert*-butylphenol), cerium (III) salt of N-nitrosophenyl hydroxylamine, phenothiazine, phenoxazine, 4-methoxynaphthol, 2,2,6,6-tetramethylpiperidine-1-oxyl, free radical, 2,2,6,6-tetramethylpiperidine, 4-hydroxy-2,2,6,6-tetramethylpiperidine-1-oxyl, free radical, nitrobenzene, and dimethylaniline; among which preferable examples include p-benzoquinone, 2,2,6,6-tetramethylpiperidine-1-oxyl, free radical, 4-hydroxy-2,2,6,6-tetramethylpiperidine-1-oxyl, free radical, and phenothiazine. The polymerization inhibitor suppresses production of the polymer impurity not only in the process of manufacturing the polymerizable monomer, but also during storage of the curable composition, and thereby suppresses degradation of pattern formability in the process of imprint.

The technique of the present invention expresses distinct effects particularly when adopted to high-boiling-point polymerizable monomer which cannot readily be purified by distillation. Boiling point of the polymerizable monomer, to which the present invention may preferably be adoptable, is 200°C or above at 1 atm, more preferably 250°C or above, and still more preferably 300°C or above. For the case where the boiling point at 1 atm cannot readily be measured, the boiling point is measured under reduced pressure, and the thus-obtained boiling point under reduced pressure is converted to boiling point at 1 atm, based on the degree of reduction in pressure.

The technique of the present invention expresses distinctive effects when adopted to the polymerizable monomer

(A) having two or more polymerizable functional groups. The polymer derived from the polymerizable monomer having two or more polymerizable functional groups has a crosslinked structure, and readily grows up to have a large molecular weight, so that the pattern formability tends to largely degrade in the process of imprint. By reducing the content, such degradation in the pattern formability in the process of imprint may be suppressed.

(B) Photo-Polymerization Initiator

The curable composition for imprints of the present invention contains a photo-polymerization initiator. The photo-polymerization initiator used in the present invention may be anything so far as it can generate, upon irradiation of light, an active species which promotes polymerization of the polymerizable monomer (A). The photo-polymerization initiator may be exemplified by cationic polymerization initiator and radical polymerization initiator, wherein the radical polymerization initiator is preferable. In the present invention, a plurality of species of photo-polymerization initiator may be used in combination.

Content of the photo-polymerization initiator used for the present invention, relative to the total composition excluding solvent, is typically 0.01 to 15% by mass, preferably 0.1 to 12% by mass, and still more preferably 0.2 to 7% by mass. For the case where two or more species of photo-polymerization initiators are used, the total amount is adjusted to the above-described ranges.

A content of photo-polymerization initiator of 0.01% by mass or above is preferable since the sensitivity (quick curability), resolution, line edge roughness, and film strength tend to improve. On the other hand, a content of photo-polymerization initiator of 15% by mass or less is preferable since the transmissivity of light, coloration and handlability tend to improve. In a system containing dye and/or pigment, they may occasionally act as a radical trapping agent, and may therefore adversely affect the photo-polymerization performance and sensitivity. Taking this point into consideration, the amount of addition of the photo-polymerization initiator is optimized for this sort of application. In contrast, dye and/or pigment are not essential components in the composition used for the present invention, so that the optimum range of the photo-polymerization initiator may be different from those of curable composition for ink jet process or curable composition for color filters of liquid crystal display devices.

Commercially available initiators may be adoptable to the radical photo-polymerization initiator in the present invention. Those described in paragraph [0091] in Japanese Laid-Open Patent Publication No. 2008-105414 may preferably be used. Among them, acetophenone-base compound, acylphosphine oxide-base compound, and oxime ester-base compound are preferable from the viewpoint of curing sensitivity and absorption characteristics.

The acetophenone-base compound may preferably be exemplified by hydroxyacetophenone-base compound, dialkoxyacetophenone-base compound, and aminoacetophenone-base compound. The hydroxyacetophenone-base compound may preferably be exemplified by Irgacure (registered trademark) 2959 (1-[4-(2-hydroxyethoxy) phenyl]-2-hydroxy-2-methyl-1-propane-1-one, Irgacure (registered trademark) 184 (1-hydroxycyclohexylphenylketone), Irgacure (registered trademark) 500 (1-hydroxycyclohexylphenylketone, benzophenone), Darocur (registered trademark) 1173 (2-hydroxy-2-methyl-1-phenyl-1-propane-1-one), all of which are available from Ciba Specialty Chemicals Inc.

The dialkoxyacetophenone-base compound may preferably be exemplified by Irgacure (registered trademark) 651 (2,2-dimethoxy-1,2-diphenylethane-1-one) available from Ciba Specialty Chemicals Inc.

The aminoacetophenone-base compound may preferably be exemplified by Irgacure (registered trademark) 369 (2-benzyl -2-dimethylamino-1-(4-morpholinophenyl) butanone-1), Irgacure (registered trademark) 379(EG) (2-dimethylamino-2-(4-methylbenzyl)-1-(4-morpholine-4-yl-phenyl) butane-1-one, and Irgacure (registered trademark) 907 (2-methyl-1-[4-methylthiophenyl]-2-morpholinopropane-1-one), all of which are available from Ciba Specialty Chemicals Inc.

The acylphosphine oxide-base compound may preferably be exemplified by Irgacure (registered trademark) 819 (bis(2,4,6-trimethylbenzoyl)-phenylphosphine oxide), and Irgacure (registered trademark) 1800 (bis(2,6-dimethoxybenzoyl)-2,4,4-trimethyl-pentylphosphine oxide), all of which are available from Ciba Specialty Chemicals Inc.; and Lucirin TPO (2,4,6-trimethylbenzoyldiphenylphosphine oxide), and Lucirin TPO-L (2,4,6-trimethylbenzoylphenylethoxyphosphine oxide), all of which are available from BASF.

The oxime ester-base compound may preferably be exemplified by Irgacure (registered trademark) OXE01 (1,2-octanedione,1-[4-(phenylthio) phenyl]-2-(O-benzoyloxime)), and Irgacure (registered trademark) OXE02 (ethanone,1-[9-ethyl -6-(2-methylbenzoyl)-9H-carbazole-3-yl]-1-(O-acetyloxime)), all of which are available from Ciba Specialty Chemicals Inc.

The cation photo-polymerization initiator adoptable to the present invention is preferably sulfonium salt compound, iodonium salt compound, and oxime sulfonate compound, and may preferably be exemplified by4-methylphenyl[4-(1-methylethyl) phenyliodonium tetrakis(pentafluorophenyl)borate (PI2074, from Rhodia), 4-methylphenyl[4-(2-methylpropyl)phenyliodonium hexafluorophophate (Irgacure 250, from Ciba Specialty Chemicals Inc.), Irgacure PAG103, 108, 121 and 203 (from Ciba Specialty Chemicals Inc.).

In the invention, "light" includes not only those having with a wavelength falling within a range of ultraviolet, near-ultraviolet, far-ultraviolet, visible, infrared, and electromagnetic waves but also radiations. The radiations include, for example, microwaves, electron beams, EUV, X-rays. In addition, laser rays such as 248 nm excimer laser, 193 nm excimer laser, 172 nm excimer laser are also usable herein. These lights may be monochromatic lights (single wavelength lights) having passed through optical filters, or may be lights of different wavelengths (composite lights). For photoexposure, multiple photoexposure may be employable, and for the purpose of enhancing the film strength and the etching resistance of the composition, entire surface photoexposure may be effected after pattern formation.

While it is necessary to appropriately select the photo-polymerization initiator adoptable to the present invention depending on wavelength of a light source to be employed, those not anticipated to produce gas during stamping with a mold, or during exposure of light may be preferable. Production of gas may result in fouling of the mold, frequent need of cleaning of the mold, and degradation of accuracy of transferred pattern due to deformation of the photo-curable composition in the mold.

The curable composition for imprints of the present invention is preferably a radical-polymerizable curable composition which contains a radical polymerizable monomer as the polymerizable monomer (A), and a radical polymerization initiator which generates a radical upon irradiation of light as the (B) photo-polymerization initiator.

(Other Ingredients)

In accordance with various objects, in addition to the above ingredient, the curable composition for imprints of the invention may contain any other ingredients such as surfactant, antioxidant and polymer without impairing the effect of the invention.

- Surfactant -

Preferably, the curable composition for imprints of the invention contains a surfactant. The content of the surfactant that may be in the composition may be, for example, from 0.001 to 5% by mass of the composition, preferably from 0.002 to 4% by mass, more preferably from 0.005 to 3% by mass. In case where two or more different types of surfactants are in the composition, the total amount thereof falls within the above range. When the surfactant content in the composition falls from 0.001 to 5% by mass, it is favorable from the viewpoint of the coating uniformity, therefore hardly worsening the mold transferability owing to excessive surfactant.

As the surfactant, preferably, the composition contains at least one of a non-ionic surfactant, more preferably a fluorine-containing surfactant, a silicone-type surfactant, a fluorine-containing silicone-type surfactant, further more preferably contains both of a fluorine-containing surfactant and a silicone-type surfactant, or contains a fluorine-containing silicone-type surfactant, most preferably contains a fluorine-containing silicone-type surfactant. The fluorine-containing surfactant and the silicone-type surfactant are preferably nonionic surfactants.

"Fluorine-containing silicone-type surfactant" as referred to herein means a surfactant satisfying both the requirement of a fluorine-containing surfactant and that of a silicone-type surfactant.

Using the surfactant of the type may solve the problem of coating failures such as striation and flaky pattern formation (drying unevenness of resist film) that may occur when the curable composition for imprints of the invention is applied onto substrates on which various films are formed, for example, onto silicon wafers in semiconductor production, or onto glass square substrates, chromium films, molybdenum films, molybdenum alloy films, tantalum films, tantalum alloy films, silicon nitride films, amorphous silicon films, tin oxide-doped indium oxide (ITO) films or tin oxide films in production of liquid-crystal devices. In addition, the surfactant is effective for enhancing the flowability of the composition of the invention in the cavity of a female mold, for enhancing the mold-resist releasability, for enhancing the resist adhesiveness to substrates, and for lowering the viscosity of the composition. In particular, when the above-mentioned surfactant is added to the composition for imprints of the invention, the coating uniformity of the composition can be

greatly improved; and in coating with it using a spin coater or a slit scan coater, the composition ensures good coating aptitude irrespective of the size of the substrate to which it is applied.

Examples of the nonionic fluorine-containing surfactant usable in the invention include the surfactants disclosed at paragraph 0097 in JP-A-2008-105414.

- Antioxidant -

Preferably, the curable composition for imprints of the invention contains a known antioxidant. The content of the antioxidant to be in the composition is, for example, from 0.01 to 10% by mass of the total amount of the polymerizable monomers constituting the composition, preferably from 0.2 to 5% by mass. When two or more different types of antioxidants are in the composition, the total amount thereof falls within the above range.

The antioxidant is for preventing fading by heat or photoirradiation, and for preventing fading by various gases such as ozone, active hydrogen NOx, SOx (x is an integer), etc. Especially in the invention, the antioxidant added to the composition brings about the advantage that the cured film is prevented from being discolored and the film thickness is prevented from being reduced through decomposition. The antioxidant includes hydrazides, hindered amine-type antioxidants, nitrogen-containing heterocyclic mercapto compounds, thioether-type antioxidants, hindered phenol-type antioxidants, ascorbic acids, zinc sulfate, thiocyanates, thiourea derivatives, saccharides, nitrites, sulfites, thiosulfates, hydroxylamine derivatives, etc. Of those, preferred are hindered phenol-type antioxidants and thioether-type antioxidants from the viewpoint of their effect of preventing cured film discoloration and preventing film thickness reduction.

Commercial products of the antioxidant usable herein include Irganox 1010, 1035, 1076, 1222 (all by Ciba-Geigy); Antigene P, 3C, FR, Sumilizer S, Sumilizer GA80 (by Sumitomo Chemical) ; Adekastab AO70, AO80, AO503 (by Adeka), etc. These may be used either singly or as combined.

- Polymerization Inhibitor -

Furthermore, the curable composition for imprints of the invention preferably comprises a polymerization inhibitor. The content of the polymerization inhibitor is from 0.001 to 1% by mass, more preferably from 0.005 to 0.5% by mass, and even more preferably from 0.008 to 0.05% by mass, relative to all the polymerizable monomers, and the change in the viscosities over time can be inhibited while maintaining a high curing sensitivity by blending the polymerization inhibitor in an appropriate amount. The polymerization inhibitor may be added at the production of the polymerizable monomer or may be added the curable composition after the production of the polymerizable monomer.

- Polymer Ingredient -

The composition of the invention may contain a poly-functional oligomer having a larger molecular weight than that of the above-mentioned, other poly-functional monomer within a range capable of attaining the object of the invention, for the purpose of further increasing the crosslinking density of the composition. Examples of the photoradical-polymerizable poly-functional oligomer include various acrylate oligomers such as polyester acrylates, urethane acrylates, polyether acrylates, epoxy acrylates. The amount of the oligomer ingredient to be added to the composition may be preferably from 0 to 30% by mass of the composition except the solvent therein, more preferably from 0 to 20% by mass, even more preferably from 0 to 10% by mass, most preferably from 0 to 5% by mass.

The curable composition for imprints of the present invention may further contain a polymer component, in view of improving the dry etching resistance, imprint suitability and curability. The polymer component preferably has a polymerizable functional group in the side chain thereof. Weight-average molecular weight of the polymer component is preferably 2,000 to 100,000, and more preferably 5,000 to 50,000, in view of compatibility with the polymerizable monomer. Amount of addition of the polymer component, with respect to portion of the composition excluding the solvent, is preferably 0 to 30% by mass, more preferably 0 to 20% by mass, and most preferably 2% by mass or less. Pattern formability may be improved by adjusting the content of polymer component having a molecular weight of 2,000 or larger, with respect to the portion of the curable composition for imprints of the present invention excluding the solvent. From the viewpoint of pattern formability, as least as possible amount of resin component is preferable, and therefore the curable composition preferably contains no polymer component other than those composing the surfactant or trace amounts of additives.

- Solvent -

A solvent is used in the curable composition for imprints of the invention, in accordance with various needs. In the specification, "solvent" does not include the above polymerizable monomer. That is, the solvent in the specification, "solvent" does not have a polymerizable functional group. In particular, when a pattern having a thickness of at most

500 nm is formed, the composition preferably contains a solvent. Preferably, the solvent has a boiling point at a pressure of 1 atmosphere of from 80 to 200°C. Regarding the type of the solvent, any solvent capable of dissolving the composition may be used. Preferred are solvents having at least any one of an ester structure, a ketone structure, a hydroxyl group and an ether structure. Concretely, the solvent is preferably one or more selected from propylene glycol monomethyl ether acetate, cyclohexanone, 2-heptanone, gamma-butyrolactone, propylene glycol monomethyl ether, ethyl lactate. Most preferred is a solvent containing propylene glycol monomethyl ether acetate as securing coating uniformity.

The content of the solvent in the composition of the invention is 3% by mass or less and may be suitably optimized depending on the viscosity of the constitutive ingredients except the solvent, the coatability of the composition and the intended thickness of the film to be formed. From the viewpoint of the coatability, the solvent content may be 99% or less by mass of the composition, although the solvent is not substantively contained in the curable composition of the invention (it is present in an amount of 3% by mass or less). In forming a patter having a thickness of at most 500 nm by a spin coating or the like, the solvent content may be preferably from 20 to 99% by mass, preferably from 40 to 99% by mass, even more preferably from 70 to 98% by mass.

In addition to the above-mentioned ingredients, the curable composition for imprints of the invention may contain, if desired, UV absorbent, light stabilizer, antiaging agent, plasticizer, adhesion promoter, thermal polymerization initiator, colorant, elastomer particles, photoacid enhancer, photobase generator, basic compound, flowability promoter, defoaming agent, dispersant, etc.

(Preparation method for the curable composition for imprints)

The curable composition for imprints of the invention can be produced by mixing the above-mentioned ingredients. The ingredients may be mixed and dissolved to prepare the curable composition, generally at a temperature falling within a range of from 0°C to 100°C. After the ingredients are mixed, the resulting mixture may be filtered through a filter having a pore size of from 0.003 μm to 5.0 μm to give a solution. The filtration may be effected in plural stages, or may be repeated plural times. The solution once filtered may be again filtered. Not specifically defined, the material of the filter may be any one, for example, polyethylene resin, polypropylene resin, fluororesin, nylon resin, etc.

The viscosity of the curable composition for imprints of the invention, except the solvent therein, at 25°C is at most 100 mPa·s, more preferably from 1 to 70 mPa·s, even more preferably from 2 to 50 mPa·s, still more preferably from 3 to 30 mPa·s.

The curable composition for imprints of the invention may form a finer micropattern through photoimprint lithography, at low cost and with high accuracy. Accordingly, the composition of the invention can form micropatterns heretofore formed according to conventional lithography at low cost and with high accuracy. For example, when the composition of the invention is applied onto a substrate and the composition layer is exposed to light, cured and optionally dried (baked), then permanent films of overcoat layers or insulating films for use in liquid-crystal displays (LCD) may be formed and the formed films may be used as an etching resist in producing semiconductor integrated circuits, recording materials or flat panel displays.

In permanent films (resists for structural members) for use in liquid-crystal displays (LCD) and in resists for use for substrate processing for electronic materials, the resist is preferably prevented from being contaminated as much as possible with metallic or organic ionic impurities in order that the resist does not interfere with the performance of the products. Accordingly, the concentration of the metallic or organic ionic impurities in the curable composition for imprints of the invention is preferably at most 1000 ppm, more preferably at most 10 ppm, even more preferably at most 100 ppb.

[Patterning Method]

The patterning method (especially micropatterning method) of using the curable composition for imprints of the invention is described below. The patterning method of the invention comprises applying the curable composition for imprints of the invention onto a substrate or a support (base) to form a patterning layer thereon; pressing a mold against the surface of the patterning layer; and irradiating the patterning layer with light, thereby curing the composition of the invention to form a micropattern.

Preferably, the curable composition for imprints of the invention is, after irradiated with light, further heated and cured. Concretely, at least the composition of the invention is applied onto a substrate (base or support) and optionally dried to form a layer comprising the composition of the invention (patterning layer), thereby preparing a pattern acceptor (having the patterning layer formed on the substrate), then a mold is pressed against the surface of the patterning layer of the pattern acceptor to thereby transfer the mold pattern onto the pattern acceptor, and the resulting micropatterned layer is cured through photoirradiation. The photoimprint lithography of the patterning method of the invention may enable lamination and multi-layer patterning, and therefore may be combined with ordinary imprint technology.

The patterning method (pattern transferring method) with the curable composition for imprints of the invention is described concretely hereinunder.

In the patterning method of the invention, the composition of the invention is first applied (preferably coated) onto a support to form a patterning layer thereon.

The coating method for applying the curable composition for imprints of the invention onto a substrate may be a well known coating method of, for example, a dip coating method, an air knife coating method, a curtain coating method, a wire bar coating method, a gravure coating method, an extrusion coating method, a spin coating method, a slit scanning method, an inkjet method, etc.

The thickness of the patterning method of the composition of the invention may vary depending on the use thereof, and may be from 0.03 μm to 30 μm or so. In the case where droplets are applied on a substrate by an inkjet method, the amount of the droplets is preferably 1 pl to 20 pl. Between the substrate and the patterning method of the composition of the invention, any other organic layer may be formed, such as a planarizing layer, etc. With that, the patterning layer is not kept in direct contact with the substrate, and therefore, the substrate may be prevented from being contaminated with dust or from being scratched, and the adhesiveness of the patterning layer to the substrate may be enhanced. The pattern to be formed of the composition of the invention may have good adhesiveness to the organic layer, if any, formed on the substrate.

The substrate (base or support) to which the curable composition for imprints of the invention is applied may be selected from various materials depending on its use, including, for example, quartz, glass, optical film, ceramic material, vapor deposition film, magnetic film, reflective film, metal substrate of Ni, Cu, Cr or Fe, paper, SOG (spin on glass), polymer substrate such as polyester film, polycarbonate film or polyimide film, TFT array substrate, PDP electrode plate, glass or transparent plastic substrate, electroconductive substrate of ITO, metal or the like, insulating substrate, semiconductor substrate such as silicon, silicon nitride, polysilicon, silicon oxide or amorphous silicon, which, however, are not limitative. The shape of the substrate is not also specifically defined. It may be tabular or roll. As described below, the substrate may be light-transmissive or non-light-transmissive, depending on the combination thereof with a mold.

Next, in the patterning method of the invention, a mold is pressed against the surface of the patterning layer for transferring the pattern from the mold onto the patterning layer. Accordingly, the micropattern previously formed on the pressing surface of the mold is transferred onto the patterning layer.

The mold material usable in the invention is described. IN the photoimprint lithography with the composition of the invention, a light-transmissive material is selected for at least one of the mold material and/or the substrate. In the photoimprint lithography applied to the invention, the curable composition for imprints of the invention is applied onto a substrate to form a patterning layer thereon, and a light-transmissive mold is pressed against the surface of the layer, then this is irradiated with light from the back of the mold and the patterning layer is thereby cured. Alternatively, the curable composition for photoimprints is applied onto a light-transmissive substrate, then a mold is pressed against it, and this is irradiated with light from the back of the substrate whereby the curable composition for photoimprints can be cured.

The photoirradiation may be attained while the mold is kept in contact with the layer or after the mold is released. In the invention, preferably, the photoirradiation is attained while the mold is kept in contact with the patterning layer.

The mold usable in the invention has a transferable pattern formed thereon. The pattern of the mold may be formed, for example, through photolithography or electronic beam lithography by which a pattern may be formed to a desired processing accuracy. In the invention, however, the mold patterning method is not specifically defined.

Not specifically defined, the light-transmissive mold material for use in the invention may be any one having a desired strength and durability. Concretely, its examples include glass, quartz, light-transparent resin such as PMMA or polycarbonate resin, transparent metal deposition film, flexible film of polydimethylsiloxane or the like, photocured film, metal film, etc.

The non-light-transmissive mold to be used in the invention where a light-transmissive substrate is used is not also specifically defined and may be any one having a predetermined strength. Concretely, examples of the mold material include ceramic material, deposition film, magnetic film, reflective film, metal material of Ni, Cu, Cr, Fe or the like, as well as SiC, silicon, silicon nitride, polysilicon, silicon oxide, amorphous silicon, etc. However, these are not limitative. The shape of the mold is not also specifically defined, and may be any of a tabular mold or a roll mold. The roll mold is used especially when continuous transfer in patterning is desired.

The mold for use in the patterning method of the invention may be processed for surface release treatment for the purpose of enhancing the releasability of the curable composition for imprints of the invention from the mold. The mold of the type includes those surface-treated with a silicone-type or fluorine-containing silane coupling agent, for which, for example, commercial release agents such as Daikin's Optool DSX, Sumitomo 3M's Novec EGC-1720 and others are preferred.

In photoimprint lithography with the composition of the invention, in general, the mold pressure in the patterning method of the invention is preferably at most 10 atmospheres. When the mold pressure is at most 10 atmospheres, then the mold and the substrate are hardly deformed and the patterning accuracy tends to increase. It is also favorable since the pressure unit may be small-sized since the pressure to be given to the mold may be low. The mold pressure is preferably selected from the region capable of securing the mold transfer uniformity, within a range within which the

residual film of the curable composition for imprints in the area of mold pattern projections may be reduced.

In the patterning method of the invention, the dose of photoirradiation in the step of irradiating the patterning layer with light may be sufficiently larger than the dose necessary for curing. The dose necessary for curing may be suitably determined depending on the degree of consumption of the unsaturated bonds in the curable composition for imprints and on the tackiness of the cured film as previously determined.

In the photoimprint lithography applied to the invention, the substrate temperature in photoirradiation may be room temperature; however, the photoirradiation may be attained under heat for enhancing the reactivity. In the previous stage of photoirradiation, preferably, the system is kept in vacuum as effective for preventing contamination with bubbles or contamination with oxygen or for preventing the reduction in reactivity, and as effective for enhancing the adhesiveness of the curable composition for imprints with mold. The system may be subjected to photoirradiation while still kept in vacuum. In the patterning method of the invention, the vacuum degree in photoirradiation is preferably from $10^{-1}$ Pa to ordinary pressure.

Light to be used for photoirradiation to cure the curable composition for imprints of the invention is not specifically defined. For example, it includes light and irradiations with a wavelength falling within a range of high-energy ionizing radiation, near-ultraviolet, far-ultraviolet, visible, infrared, etc. The high-energy ionizing radiation source includes, for example, accelerators such as Cockcroft accelerator, Handegraf accelerator, linear accelerator, betatoron, cyclotron, etc. The electron beams accelerated by such an accelerator are used most conveniently and most economically; but also are any other radioisotopes and other radiations from nuclear reactors, such as y rays, X rays, $\alpha$ rays, neutron beams, proton beams, etc. The UV sources include, for example, UV fluorescent lamp, low-pressure mercury lamp, high-pressure mercury lamp, ultra-high-pressure mercury lamp, xenon lamp, carbon arc lamp, solar lamp, etc. The radiations include microwaves, EUV, etc. In addition, laser rays for use in microprocessing of semiconductors, such as LED, semiconductor laser ray, 248 nm KrF excimer laser ray, 193 nm ArF excimer laser ray and others, are also favorably used in the invention. These lights may be monochromatic lights, or may also be lights of different wavelengths (mixed lights).

In photoexposure, the light intensity is preferably within a range of from 1 mW/$cm^2$ to 50 mW/$cm^2$. When the light intensity is at least 1 mW/$cm^2$, then the producibility may increase since the photoexposure time may be reduced; and when the light intensity is at most 50 mW/$cm^2$, then it is favorable since the properties of the permanent film formed may be prevented from being degraded owing to side reaction. Also preferably, the dose in photoexposure is within a range of from 5 mJ /$cm^2$ to 1000 mJ /$cm^2$. When the dose is less than 5 mJ /$cm^2$, then the photoexposure margin may be narrow and there may occur problems in that the photocuring may be insufficient and the unreacted matter may adhere to mold. On the other hand, when the dose is more than 1000 mJ /$cm^2$, then the composition may decompose and the permanent film formed may be degraded.

Further, in photoexposure, the oxygen concentration in the atmosphere may be controlled to be less than 100 mg/L by introducing an inert gas such as nitrogen or argon into the system for preventing the radical polymerization from being retarded by oxygen.

In the patterning method of the invention, after the pattern layer is cured through photoirradiation, if desired, the cured pattern may be further cured under heat given thereto. The method may additionally include the post-curing step. Thermal curing of the composition of the invention after photoirradiation is preferably attained at 150 to 280°C, more preferably at 200 to 250°C. The heating time is preferably from 5 to 60 minutes, more preferably from 15 to 45 minutes.

[Pattern]

The pattern thus formed according to the patterning method of the invention as described in the above can be used as a permanent film (resist for structural members) for use in liquid-crystal displays (LCD) and others, or as an etching resist. After its production, the composition of the invention may be bottled in a container such as a gallon bottle or a coated bottle, and may be transported or stored. In this case, the container may be purged with an inert gas such as nitrogen, argon or the like for preventing the composition therein from being degraded. The composition may be transported or stored at ordinary temperature, but for preventing the permanent film from being degraded, it is preferably transported or stored at a controlled temperature of from -20°C to 0°C. Needless-to-say, the composition is shielded from light to such a level on which its reaction does not go on.

The pattern formed by using the curable composition for imprints of the present invention is also excellent in solvent resistance. While it is preferable that the curable composition for imprints of the present invention is highly durable against a wide variety of solvents, it is particularly preferable that the curable composition does not cause variation in the film thickness typically when immersed in N-methylpyrrolidone, which is a solvent generally used in the process of manufacturing the substrate, at 25°C for 10 minutes.

The pattern formed according to the patterning method of the invention is useful as an etching resist. In case where the composition for imprints of the invention is used as an etching resist, a nano-order micropattern is first formed

on a substrate such as a silicon wafer with a thin film of $SiO_2$ or the like formed thereon, according to the patterning method of the invention. Next, this is etched with hydrogen fluoride in wet etching, or with $CF_4$ in dry etching, thereby forming a desired pattern on the substrate. The curable composition for imprints of the invention exhibits especially good etching resistance in dry etching.

EXAMPLES

The characteristics of the invention are described more concretely with reference to Production Examples and Examples given below. In the following Examples, the material used, its amount and the ratio, the details of the treatment and the treatment process may be suitably modified or changed not overstepping the scope of the invention. Accordingly, the invention should not be limitatively interpreted by the Examples mentioned below.

In GPC measurement in Examples, 2695 separation module manufactured by Waters was used and the column used herein was a column which is obtained by connecting three of KF-805 manufactured by Shodex.

Tetrahydrofuran was used as an eluant solution, and the flow velocity was 1 mL/min at 40°C. As a decetror, a RI detector (2414, from Waters Corpoartion), or a light scattering detector (DAWN-EOS, from Wyatt Technology Corpoartion) was used. DAWN-EOS was connected to WyattQels and the scattering light at 90 degree was observed.

Turbidity was measured using SEP-PT-706D from Mitsubishi Chemical Corporation.

Viscosity at 25°C, and boiling point at 1 atm of the polymerizable monomers used in Examples were shown in Table 1 below. The viscosity was measured using a rotational viscometer Model RE-80L from Toki Sangyo Co., Ltd., at 25±0.2°C.

(R1) Polymerizable Monomer: Synthesis of *m*-Xylylene Diacrylate

To 1, 000 ml of distilled water, 411 g of sodium hydroxide was added, the solution was cooled on ice, and 781 g of acrylic acid was dropwisely added. To the mixture, 107 g of benzyl tributylammonium chloride and 600 g of α,α'-dichlorometaxylene were added, and the mixture was allowed to react at 85°C for 7 hours. To the reaction solution, 1,600 ml of ethyl acetate was added, the organic layer was then sequentially washed with a 1% aqueous hydrochloric acid solution, a 1% aqueous tetramethylammonium hydroxide solution and distilled water, the organic layer was condensed *in vacuo* so as to reduce the solvent content to 1% by mass or below, to thereby obtain a crude product (polymerizable monomer composition) which contains polymerizable monomer (R1-1). The crude product containing unpurified polymerizable monomer (R1-1) will be referred to as (R1-1). (R1-1) was found to show a viscosity at 25°C of 10.5 mPa·s. (R1-1) was also found to show a boiling point at 1 atm of 300°C or higher.

By GPC measurement of polymer content, the thus-obtained (R1-1) was found to contain 1.1% of polymer component having a weight-average molecular weight in standard polystyrene equivalence of 250,000.

(R1-1) was then dissolved in an ethyl acetate/hexane=50/50 (vol/vol) mixed solvent, to prepare a 10%-by-mass solution. The solution was appeared turbid, with a turbidity of 1,100 ppm.

(R1-1) was then polymerized using a polymerization initiator V-601 (from Wako Pure Chemical Industries, Ltd.) to obtain a polymer. The polymer was found to be insoluble to an ethyl acetate/hexane=50/50 (vol/vol) mixed solvent and to methanol, showing a solubility of only 1% by mass or below.

R1-1 itself is not part of the invention and is provided for information purposes only.

Purification of (R1-1)

Forty grams of (R1-1) obtained in the above was dissolved in an ethyl acetate/hexane (100 ml/100 ml) mixed solvent. The resultant solution was filtered through a 0.1-μm tetrafluoroethylene filter, to thereby remove solid components. From GPC measurement, the removed solid was found to be a polymer component having a weight-average molecular weight of 250,000. To the filtrate, 0.004 g of 4-hydroxy-2,2,6,6-tetramethylpiperidine-1-oxyl, free radical was added as the polymerization inhibitor, and the mixture was then condensed to obtain polymerizable monomer (R1-2). (R1-2) was found to have a viscosity at 25°C of 9.5 mPa·s.

No polymer component was detected in (R1-2) by GPC measurement of polymer content.

(R1-2) was dissolved in an ethyl acetate/hexane=50/50 (vol/vol) mixed solvent, to prepare a 10%-by-mass solution. The solution did not appear turbid, with a turbidity of 0.5 ppm.

(R1-1) and (R1-2) were mixed to prepare polymerizable monomer compositions (R1-3) to (R1-6) having different polymer contents.

[Table 1]

| | Polymer content in polymerizable monomer composition (ratio of area on GPC chart, based on RI detection) | Polymer content in polymerizable monomer composition (ratio of area on GPC chart, based on scattered light detection) | Turbidity (in 10% ethyl acetate/hexane solution (50/50 vol/vol)) |
|---|---|---|---|
| R1-1* | 1.1% | 92% | 1,100 ppm |
| R1-2 | not detected | not detected | 0.5 ppm |
| R1-3 | 0.09% | 80% | 600 ppm |
| R1-4 | not detected | 55% | 390 ppm |
| R1-5 | not detected | 20% | 80 ppm |
| R1-6 | not detected | 3% | 3.5 ppm |
| * R1-1 itself is not part of the invention and is provided for information purposes only. | | | |

(Preparation of Curable Composition for imprints)

Curable compositions were prepared by adding photo-polymerization initiator P-2 (2% by mass), perfluorohexylethyl acrylate (1% by mass), surfactant W-1 (0.1% by mass), and surfactant W-2 (0.04% by mass), listed below, to each of (R1-1) to (R1-6).

<Photo-Polymerization Initiators>

P-1: Irgacure-379EG (from Ciba Specialty Chemicals Corporation)
P-2: 2,4,6-trimethylbenzoyl-ethoxyphenyl-phosphine oxide (Lucirin TPO-L from BASF)
P-3: Irgacure-OXE01 (from Ciba Specialty Chemicals Corporation)

<Surfactants>

W-1: fluorine-containing surfactant (from Tochem Products Corporation)
W-2: silicone-base surfactant (Megafac Paintad 31, from Dainippon Ink and Chemicals, Inc.)

<Evaluation of Pattern Formability>

Each of the curable compositions prepared in the above was spin-coated on a silicon substrate to form a film, a mold having a 40-nm-wide, 80-nm deep line/space (1/1) pattern formed thereon and having silane coupling agent (Optool HD1100, from Daikin Industries Ltd.) having a perfluoropolyether structure coated on the surface thereof for assisting mold releasing was placed on the film, the film was allowed to cure under irradiation of light of mercury lamp which contains 365-nm light at an illuminance of 10 mW/cm$^2$, and an exposure energy 200 mJ/cm2, under nitrogen flow while being pressurized by the mold at 1 mPa, then the mold was slowly separated after the curing. The obtained pattern was observed under a scanning electron microscope, and (I) large pattern defect characterized by failure of pattern transfer over an area of 1 μm or larger in diameter, and (II) omission of pattern such as chipping, tumble, exfoliation, etc. were evaluated according to criteria below.

(I) Large Pattern Defect Characterized by Failure of Pattern Transfer over an Area of 1 μm or Larger in Diameter

a: large pattern defect not observed.
b: large pattern defect slightly observed.
c: large pattern defect observed a lot.

(II) Small Omission of Pattern such as Chipping, Tumble, Exfoliation, etc.

A: pattern omission not observed.
B: pattern omission slightly observed.
C: pattern omission observed a lot.

[Table 2]

| | Types of polymerizable monomer composition | Large pattern defect | Omission of pattern |
|---|---|---|---|
| Example 1 | R1-2 | a | A |
| Example 2 | R1-6 | a | A |
| Example 3 | R1-5 | b | A |
| Example 4 | R1-4 | b | B |
| Example 5 | R1-3 | b | B |
| Comparative Example 1 | R1-1 | c | C |

(R2) Polymerizable Monomer: Synthesis of 2-Naphthylmethyl Acrylate

Under nitrogen flow, 600 g of 2-methylnaphthalene was dissolved in 6,000 ml of ethyl acetate, 422 g of 1,3-dibromo-5,5-dimethylhydantoin was added to the solution, and the mixture was heated to 40°C. To the mixture, 7.4 g of V-65 from Wako Pure Chemical Industries, Ltd. was added, and the mixture was allowed to react at 40°C for 7 hours. The reaction mixture was further allowed to react at 65°C for 3 hours, and allowed to stand for cooling. The reaction solution was sequentially washed with aqueous sodium hydrogen carbonate solution and distilled water, and then condensed. To the condensate, 3, 600 ml of isopropanol was added, the mixture was stirred for 30 minutes, 900 ml of distilled water was further added, and the mixture was stirred for another 30 minutes. Solid deposited therein was collected by filtration, dissolved in 1,800 ml of isopropanol, the mixture was stirred for 30 minutes, 450 ml of distilled water was further added, and the mixture was stirred for another 30 minutes. Solid deposited therein was collected and dried, to thereby yield 300 g of 2-bromomethylnaphthalene.

To 200 ml of distilled water, 81.4 g of sodium hydroxide was added, and 147 g of acrylic acid was dropwisely added thereto under cooling on ice. To the mixture, 42.4 g of benzyl tributylammonium chloride and 300 g of 2-bromomethylnaphthalene were added, and the mixture was allowed to react at 75°C for 2 hours. To the reaction solution, 800 ml of an ethyl acetate/hexane=2/8 (vol/vol) mixed solvent was added, the organic layer was sequentially washed with an aqueous 1% hydrochloric acid solution, an aqueous 1% tetramethylammonium hydroxide solution and distilled water, and the organic layer was condensed *in vacuo* so as to reduce the solvent content to 1% by mass or below, to thereby obtain polymerizable monomer composition (R2-1). (R2-1) was found to have a viscosity at 25°C of 11.8 mPa·s, and a boiling point at 1 atm of approximately 300°C.

By GPC measurement of polymer content (RI detection), the thus-obtained (R2-1) was found to contain 1.1% of polymer component having a weight-average molecular weight in standard polystyrene equivalence of 190,000.

Polymerizable monomer (R2-1) was then dissolved in hexane to prepare a 10%-by-mass solution. The solution was appeared turbid, with a turbidity of 1,300 ppm.

(R2-1) was then polymerized using a polymerization initiator V-601 (from Wako Pure Chemical Industries, Ltd.) to obtain a polymer having a weight-average molecular weight of 80,000. The polymer was found to be insoluble to hexane and methanol, showing a solubility of only 1% by mass or below.

Purification of (R2-1)

Forty grams of (R2-1) was dissolved in 200 ml of hexane. The solution was then filtered through a 0.1-μm tetrafluoroethylene filter, to thereby remove solid components. From GPC measurement (RI detection), the removed solid was found to be a polymer component having a weight-average molecular weight of 200,000. To the filtrate, 0.004 g of p-benzoquinone was added as the polymerization inhibitor, and the mixture was then condensed to obtain polymerizable monomer (R2-2). (R2-2) was found to have a viscosity at 25°C of 10.3 mPa·s.

No polymer component was detected in the thus-obtained polymerizable monomer (R2-2) by GPC measurement of polymer content.

(R2-2) was dissolved in hexane to prepare a 10%-by-mass solution. The solution did not appear turbid, with a turbidity of 0.3 ppm.

To each of the polymerizable monomer compositions listed in Table below, the above-described photo-polymerization initiator P-1 (2% by mass), and compound RX (1% by mass) shown below were mixed, to prepare a curable composition. Ratios of mixing of two types of polymerizable monomer composition were given in parentheses. The curable compositions were evaluated for the pattern formability, according to the above-described method.

Compound RX

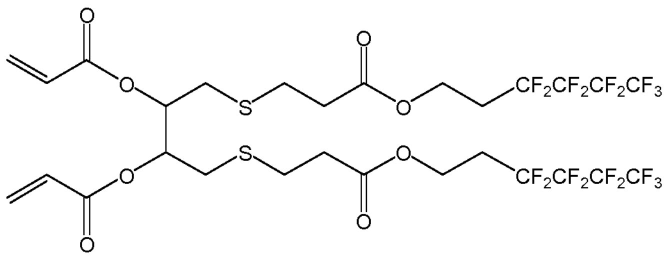

[Table 3]

| | Polymer content in polymerizable monomer composition (ratio of area on GPC chart, based on RI detection) | Polymer content in polymerizable monomer composition (ratio of area on GPC chart, based on scattered light detection) | Turbidity (in 10% hexane solution) |
|---|---|---|---|
| R2-1* | 1.1% | 55% | 1,300 ppm |
| R2-2 | not detected | not detected | 0.3 ppm |

R2-1 is not part of the invention and is provided for information purposes only.

[Table 4]

| | Polymerizable monomer composition (w/w) | | Large pattern defect | Omission of pattern |
|---|---|---|---|---|
| Example 6 | R1-2(50) | R2-2(50) | a | A |
| Example 7 | R1-2(50) | R2-1(50) | b | A |
| Example 8 | R1-1(50) | R2-2(50) | b | B |
| Comparative Example 2 | R1-1(50) | R2-1(50) | b | C |

Each of the photo-curabile compositions obtained in Example 6 and Comparative Example 2 was jetted onto a silicon wafer using an ink jet printer manufactured by FUJIFILM Dimatix Inc., at a droplet volume per nozzle of 1 pl, so as to form dots arranged in a square pattern at 100 μm intervals, under timing control of jetting. Jetting performance was evaluated based on ratio of clogged nozzles, after consecutive jetting over the entire surfaces of ten slices of 4-inch wafers. Smaller value is preferable since it means less incidence of jetting failure after the consecutive jetting. After the consecutive jetting over ten slices of 4-inch wafers, the mold described below was placed on the tenth wafer at 25°C, 1 atm, allowed to stand under nitrogen flow for one minute, then the wafer was irradiated by light from the mold side, using a mercury lamp at 300 mJ/$cm^2$. After the irradiation, the mold was separated, and a pattern was obtained. Pattern formability was evaluated according to the method described in the above.

[Table 5]

| | Ratio of clogged nozzles | Large pattern defect | Omission of pattern |
|---|---|---|---|
| Example 6 | 0% | a | A |
| Comparative Example 2 | 25% | C | C |

The compositions of Examples were found to show good jetting performance and good pattern formability, when the pattern was transferred by placing the curable compositions on the substrates according to the ink jet process.

Each of commercially available polymerizable monomers listed below were dissolved in methanol to prepare a 20%-by-mass solution. The solution was filtered through a 0.1-μm tetrafluoroethylene filter to remove solid components. As the polymerization inhibitor, 300 ppm of phenothiazine was added to the filtrate, and the solution was condensed *in vacuo* so as reduce the residual solvent down to 1% by mass or below.

Each of the commercially available polymerizable monomers was measured with respect to polymer contents before and after purification, and turbidity when dissolved in methanol to give a 10% solution.

[Table 6]

| Polymerizable monomer | Boiling point at 1 atm (°C) | | Abbr. | Polymer content (RI detection) | Turbidity ppm |
|---|---|---|---|---|---|
| Nonanediol diacrylate | >300°C | unpurified | R3-1 | 1.3 | 1,700 |
| | | purified | R3-2 | not detected | 0.4 |
| Isoboronyl acrylate | 270°C | unpurified | R4-1 | 1.1 | 1,050 |
| | | purified | R4-2 | not detected | 0.2 |
| Trimethylolpropane triacrylate | >300°C | unpurified | R5-1 | 2.1 | 1,100 |
| | | purified | R5-2 | not detected | 0.8 |
| Tricyclodecanedimethanol diacrylate | >300°C | unpurified | R6-1 | 1.1 | 1,500 |
| | | purified | R6-2 | not detected | 0.7 |
| (R3-1, R4-1, R5-1 and R6-1 are not part of the invention and are provided for information purposes only). | | | | | |

The polymerizable monomers adopted herein are as follow:

nonanediol diacrylate: Biscoat #260, from Osaka Organic Chemical Industry, Ltd.;
isoboronylacrylate: IBXA, from Osaka Organic Chemical Industry, Ltd.;
trimethylolpropane triacrylate: Aronix M-309, from TOAGOSEI Co., Ltd.; and
tricyclodecanedimethanol diacrylate: NK ester A-DCP, from Shin-Nakamura Chemical Co., Ltd.

Photo-polymerization initiator P-3 (2% by mass), and acryl-modified silicone oil (X-22-164AS, from Shin-Etsu Chemical Co., Ltd.) (2% by mass) were added to each of the polymerizable monomers of the commercially available products listed in the above, and to each of the purified polymerizable monomers, to prepare curable compositions. The obtained curable compositions were evaluated for the pattern formability according to the method described in the above. Ratio of mixing of two species of polymerizable monomer composition was given in the parentheses.

[Table 7]

| | Polymerizable monomer composition (w/w) | | Large pattern defect | Omission of pattern |
|---|---|---|---|---|
| Example 9 | R3-2 (50) | R5-2 (50) | a | B |
| Example 10 | R4-2 (50) | R6-2 (50) | a | A |
| Comparative Example 3 | R3-1 (50) | R5-1 (50) | b | C |
| Comparative Example 4 | R4-1 (50) | R6-1 (50) | b | C |

As is obvious from Table in the above, the curable compositions for imprints of the present invention were found to be excellent in the pattern formability. In contrast, the curable compositions for imprints of Comparative Examples were found to be poor in the pattern formability, despite the polymer contents are extremely small.

The present disclosure relates to the subject matter contained in Japanese Patent Application No. 88344/2010 filed on April 7, 2010 and Japanese Patent Application No. 048810/2011 filed on March 7, 2011.

The foregoing description of preferred embodiments of the invention has been presented for purposes of illustration and description, and is not intended to be exhaustive or to limit the invention to the precise form disclosed.

The description was selected to best explain the principles of the invention and their practical application to enable others skilled in the art to best utilize the invention in various embodiments and various modifications as are suited to the particular use contemplated.

## Claims

1. A method of manufacturing a curable composition for imprints, which includes a method of manufacturing a polymerizable monomer (A) for imprint, wherein the method of manufacturing the polymerizable monomer (A) for imprint includes removing a polymer impurity containing at least one species of the polymerizable monomer (A) as a repeating unit by:

   i. mixing a solvent with the polymerizable monomer (A) and the polymer impurity, and
   ii. allowing the polymer impurity to deposit,

   wherein the solvent is capable of dissolving at least one species of the polymerizable monomer (A), and the solubility of the polymer impurity in the solvent is typically 5% by mass or below,
   wherein an imprint means a pattern transfer in a size of from 1 nm to 10 mm, wherein the method further comprises the step of adding a polymerization initiator (B), and
   wherein the curable composition for imprints contains 3% by mass or less solvent.

2. The method according to Claim 1, wherein the solvent contains at least one species selected from alcoholic solvent, hydrocarbon solvent, water and ester solvent.

3. The method according to any one of Claims 1 and 2, wherein the polymerizable monomer (A) has a boiling point of 200°C or higher at 1 atm, or after being converted to 1 atm; and/or wherein the polymerizable monomer (A) has two or more polymerizable functional groups; and/or wherein the polymerizable monomer (A) contains an aromatic group and/or alicyclic hydrocarbon group.

4. The method according to any one of Claims 1 to 3, wherein the polymerizable monomer (A) is (meth)acrylate.

5. The method according to Claim 1, wherein the polymerizable monomer (A) is a liquid at 25°C, or solid having a melting point of 60°C or less.

6. A curable composition for imprints manufactured by the method according to any one of Claims 1 to 4.

7. A curable composition for imprints manufactured by the method according to claim 1,
   wherein the ratio of area (peak ratio) in the curable composition corresponding to components ascribable to the polymer impurity relative to the polymerizable monomer (A) is 1% or smaller when measured by gel permeation chromatography (GPC) using a differential refractometer (RI detector),
   wherein GPC was carried out on a 2695 separation module manufactured by Waters with a column obtained by connecting three of KF-805 manufactured by Shodex, tetrahydrofuran as the eluant solution, and a flow velocity of 1 mL/min at 40°C,
   wherein detection is carried out using a 2414 RI detector from Waters Corporation.

8. The curable composition for imprints according to Claim 7, which has a turbidity of 1,000 ppm or below when dissolved in the solvent defined in claim 1 so that the total content of the polymerizable monomer (A) and the polymer impurity is 10% by mass of the solvent,
   wherein turbidity is measured using SEP-PT-706D from Mitsubishi Chemical Corporation.

9. The curable composition for imprints according to Claim 7 or 8, wherein the polymerizable monomer (A) is the same as that defined in claim 3.

10. The curable composition for imprints according to any one of Claims 7 to 9, wherein the polymerizable monomer is (meth)acrylate.

11. A method of forming a pattern, which includes:

forming a pattern-forming layer by applying, on a support, the curable composition for imprints according to any one of Claims 6 to 10;
pressing a mold against the surface of the pattern-forming layer; and
irradiating light onto the pattern-forming layer.

**12.** The method of forming a pattern according to Claim 11, wherein the curable composition for imprints is applied on the support by spin coating or ink jet process.

## Patentansprüche

**1.** Verfahren zur Herstellung einer härtbaren Zusammensetzung für Abdrücke, welches ein Verfahren zur Herstellung eines polymerisierbaren Monomers (A) für Abdrücke umfaßt, worin das Verfahren zur Herstellung des polymerisierbaren Monomers (A) für Abdrücke das Entfernen einer Polymer-Verunreinigung umfaßt, die mindestens eine Spezies des polymerisierbaren Monomers (A) als eine Wiederholungseinheit enthält, durch:

i. Mischen eines Lösungsmittels mit dem polymerisierbaren Monomer (A) und der Polymer-Verunreinigung und
ii. Ermöglichen, daß die Polymer-Verunreinigung abgeschieden wird,

worin das Lösungsmittel in der Lage ist, zumindest eine Spezies des polymerisierbaren Monomers (A) zu lösen, und die Löslichkeit der Polymer-Verunreinigung in dem Lösungsmittel typischerweise 5 Masse-% oder weniger beträgt,
worin ein Abdruck eine Strukturübertragung mit einer Größe von 1 nm bis 10 mm bezeichnet, worin das Verfahren ferner den Schritt des Zugebens eines Polymerisationsinitiators (B) umfaßt, und worin die härtbare Zusammensetzung für Abdrücke 3 Masse-% oder weniger Lösungsmittel enthält.

**2.** Verfahren gemäß Anspruch 1, worin das Lösungsmittel zumindest eine Spezies enthält, ausgewählt aus alkoholischem Lösungsmittel, KohlenwasserstoffLösungsmittel, Wasser und Ester-Lösungsmittel.

**3.** Verfahren gemäß irgendeinem der Ansprüche 1 und 2, worin das polymerisierbare Monomer (A) einen Siedepunkt von 200°C oder höher bei 1 atm aufweist, oder nachdem er zu 1 atm umgewandelt worden ist; und/oder worin das polymerisierbare Monomer (A) zwei oder mehr polymerisierbare funktionelle Gruppen aufweist; und/oder worin das polymerisierbare Monomer (A) eine aromatische Gruppe und/oder eine alicyclische Kohlenwasserstoff-Gruppe aufweist.

**4.** Verfahren gemäß irgendeinem der Ansprüche 1 bis 3, worin das polymerisierbare Monomer (A) ein (Meth)acrylat ist.

**5.** Verfahren gemäß Anspruch 1, worin das polymerisierbare Monomer (A) bei 25°C eine Flüssigkeit ist, oder ein Feststoff mit einem Schmelzpunkt von 60°C oder niedriger ist.

**6.** Härtbare Zusammensetzung für Abdrücke, hergestellt durch das Verfahren gemäß irgendeinem der Ansprüche 1 bis 4.

**7.** Härtbare Zusammensetzung für Abdrücke, hergestellt durch das Verfahren gemäß Anspruch 1,
worin der Anteil der Fläche (Peak-Anteil) in der härtbaren Zusammensetzung, die den Komponenten entspricht, die der Polymer-Verunreinigung zuzuschreiben sind, relativ zu dem polymerisierbaren Monomer (A), 1 % oder kleiner ist, wenn mittels GelPermeationschromatographie (GPC) unter Verwendung eines differentiellen Refraktometers (RI-Detektor) gemessen wird,
worin die GPC auf einem 2695-Trennungsmodul durchgeführt wird, hergestellt von Waters, mit einer Säule, die durch Verbinden von drei KF-805, hergestellt von Shodex, erhalten wird, worin Tetrahydrofuran als eluierendes Lösungsmittel verwendet wird, und worin die Flußgeschwindigkeit 1 ml/min bei 40°C beträgt,
worin die Detektion durchgeführt wird unter Verwendung eines 2414-RI-Detektors von Waters Corporation.

**8.** Härtbare Zusammensetzung für Abdrücke gemäß Anspruch 7, welches eine Trübung von 1000 ppm oder weniger aufweist, wenn es in dem in Anspruch 1 definierten Lösungsmittel gelöst wird, so daß die Gesamtmenge des polymerisierbaren Monomers (A) und der Polymer-Verunreinigung 10 Masse-% des Lösungsmittels beträgt,
worin die Trübung unter Verwendung von SEP-PT-706D von Mitsubishi Chemical Corporation gemessen wird.

9. Härtbare Zusammensetzung für Abdrücke gemäß Anspruch 7 oder 8, worin das polymerisierbare Monomer (A) das gleiche ist, wie es in Anspruch 3 definiert ist.

10. Härtbare Zusammensetzung für Abdrücke gemäß irgendeinem der Ansprüche 7 bis 9, worin das polymerisierbare Monomer ein (Meth)acrylat ist.

11. Verfahren zum Bilden einer Struktur, welches umfaßt:

Bilden einer Struktur-bildenden Schicht durch Auftragen der härtbaren Zusammensetzung für Abdrücke gemäß irgendeinem der Ansprüche 6 bis 10 auf einen Träger;
Drücken einer Form gegen die Oberfläche der Struktur-bildenden Schicht; und
Bestrahlen von Licht auf die Struktur-bildende Schicht.

12. Verfahren zum Bilden einer Struktur gemäß Anspruch 11, worin die härtbare Zusammensetzung für Abdrücke durch Rotationsbeschichtung oder einen Tintenstrahlprozeß auf den Träger aufgetragen wird.

**Revendications**

1. Procédé de fabrication d'une composition durcissable pour impressions, qui comporte un procédé de fabrication d'un monomère polymérisable (A) pour impression, dans lequel le procédé de fabrication du monomère polymérisable (A) pour impression comporte l'élimination d'une impureté polymère contenant au moins une espèce du monomère polymérisable (A) en tant qu'unité de répétition en :

i. mélangeant un solvant avec le monomère polymérisable (A) et l'impureté polymère, et
ii. laissant l'impureté polymère se déposer,

dans lequel le solvant est capable de dissoudre au moins une espèce du monomère polymérisable (A), et la solubilité de l'impureté polymère dans le solvant est typiquement de 5% en masse ou inférieure,
dans lequel une impression veut dire un transfert de motif dans une taille allant de 1 nm à 10 nm, dans lequel le procédé comprend en outre l'étape d'addition d'un initiateur de polymérisation (B), et dans lequel la composition durcissable pour impressions contient 3% en masse ou moins de solvant.

2. Le procédé selon la revendication 1, dans lequel le solvant contient au moins une espèce choisie parmi un solvant alcoolique, un solvant hydrocarboné, de l'eau et un solvant ester.

3. Le procédé selon l'une quelconque des revendications 1 et 2, dans lequel le monomère polymérisable (A) a un point d'ébullition de 200°C ou supérieur à 1 atm, ou après avoir été converti à 1 atm ; et/ou dans lequel le monomère polymérisable (A) a deux ou plusieurs groupes fonctionnels polymérisables; et/ou dans lequel le monomère polymérisable (A) contient un groupe aromatique et/ou un groupe hydrocarboné alicyclique.

4. Le procédé selon l'une quelconque des revendications 1 à 3, dans lequel le monomère polymérisable (A) est le (méth)acrylate.

5. Le procédé selon la revendication 1, dans lequel le monomère polymérisable est un liquide à 25°C, ou un solide ayant un point de fusion de 60°C ou moins.

6. Composition durcissable pour impressions fabriquée par le procédé selon l'une quelconque des revendications 1 à 4.

7. Composition durcissable pour impressions fabriquée par le procédé selon la revendication 1,
dans laquelle le rapport d'aire (rapport de pic) dans la composition durcissable correspondant aux composants attribuables à l'impureté polymère par rapport au monomère polymérisable (A) est de 1% ou inférieur lorsque mesuré par chromatographie à perméation de gel (CPG) utilisant un réfractomètre différentiel (détecteur RI),
dans laquelle la CPG était effectuée sur un module de séparation 2695 fabriqué par Waters avec une colonne obtenue en connectant trois KF-805 fabriquées par Shodex, du tétrahydrofuranne en tant que solution d'élution, et une vitesse de flux de 1 mL/min à 40°C,
dans laquelle la détection est effectuée en utilisant un détecteur 2414 RI de Waters Corporation.

8. La composition durcissable pour impressions selon la revendication 7, qui a une turbidité de 1,000 ppm ou inférieure lorsque dissoute dans le solvant défini dans la revendication 1 de telle sorte que la teneur totale du monomère polymérisable (A) et l'impureté polymère est de 10% en masse du solvant,
dans laquelle la turbidité est mesurée en utilisant un SEP-PT-706D de Mitsubishi Chemical Corporation.

9. La composition durcissable pour impressions selon la revendication 7 ou 8, dans laquelle le monomère polymérisable (A) est le même que celui défini dans la revendication 3.

10. La composition durcissable pour impressions selon l'une quelconque des revendications 7 à 9, dans laquelle le monomère polymérisable est le (méth)acrylate.

11. Procédé pour former un motif, qui comporte :

    la formation d'une couche de formation de motif en appliquant, sur un support, la composition durcissable pour impressions selon l'une quelconque des revendications 6 à 10 ;
    le pressage d'un moule contre la surface de la couche de formation de motif ; et
    l'irradiation de lumière sur la couche de formation de motif.

12. Le procédé de formation de motif selon la revendication 11, dans lequel la composition durcissable pour impressions est appliquée sur le support par dépôt centrifuge ou un procédé de jet d'encre.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 5772905 A
- US 5956216 A
- US 5259926 A
- JP 2005197699 A
- JP 2005301289 A
- JP 2004240241 A
- US 2011003909 A
- JP 2009073078 A
- JP 11100378 A
- JP 2906245 B
- JP 2926262 B
- JP 2008105414 A
- JP 2010088344 A
- JP 2011048810 A


### Non-patent literature cited in the description


- **S. CHOU et al.** *Appl. Phys. Lett.,* 1995, vol. 67, 3114
- **M. COLBUN et al.** *Proc. SPIE,* 1999, vol. 3676, 379
- Lecture of Experimental Chemistry. Organic Synthesis II. Maruzen, 1992, vol. 20, 213
- The chemistry of heterocyclic compounds - Small Ring Heterocycles. Oxiranes. An Interscience Publication, 1985
- **YOSHIMURA.** *Adhesive,* 1985, vol. 29 (12), 32
- **YOSHIMURA.** *Adhesive,* 1986, vol. 30 (5), 42
- **YOSHIMURA.** *Adhesive,* 1986, vol. 30 (7), 42
- **STEPHEN. C. LAPIN.** *Polymers Paint Colour Journal,* 1988, vol. 179 (4237), 321